(19) Europäisches Patentamt
European Patent Office
Office européen des brevets

(11) **EP 2 957 057 B1**

(12) **FASCICULE DE BREVET EUROPEEN**

(45) Date de publication et mention
de la délivrance du brevet:
**15.08.2018  Bulletin 2018/33**

(21) Numéro de dépôt: **14708619.3**

(22) Date de dépôt: **11.02.2014**

(51) Int Cl.:
*H04L 1/00* (2006.01)   *H03M 13/29* (2006.01)
*H04L 25/03* (2006.01)   *H04L 25/06* (2006.01)
*H04L 1/06* (2006.01)

(86) Numéro de dépôt international:
**PCT/FR2014/050264**

(87) Numéro de publication internationale:
**WO 2014/125207 (21.08.2014 Gazette 2014/34)**

(54) **PROCEDE ET DISPOSITIF DE PREDICTION DES PERFORMANCES D'UN SYSTEME DE COMMUNICATION SUR UN CANAL DE TRANSMISSION**

VERFAHREN UND VORRICHTUNG ZUR VORHERSAGE DER LEISTUNGEN EINES KOMMUNIKATIONSSYSTEMS ÜBER EINEN ÜBERTRAGUNGSKANAL

METHOD AND APPARATUS FOR PREDICTING PERFORMANCES OF A COMMUNICATION SYSTEM ON A TRANSMISSION CHANNEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **13.02.2013   FR 1351212**

(43) Date de publication de la demande:
**23.12.2015   Bulletin 2015/52**

(73) Titulaire: **Orange**
**75015 Paris (FR)**

(72) Inventeurs:
• **VISOZ, Raphaël**
**F-92170 Vanves (FR)**
• **BERTHET, Antoine**
**F-92290 Chatenay Malabry (FR)**
• **NING, Baozhu**
**F-94230 Cachan (FR)**

(74) Mandataire: **Fontenelle, Sandrine et al**
**Cabinet Beau de Loménie**
**158, rue de l'Université**
**75340 Paris Cedex 07 (FR)**

(56) Documents cités:
• **RAPHAEL VISOZ ET AL: "Semi-Analytical Performance Prediction Methods for Iterative MMSE-IC Multiuser MIMO Joint Decoding", IEEE TRANSACTIONS ON COMMUNICATIONS, IEEE SERVICE CENTER, PISCATAWAY, NJ. USA, vol. 58, no. 9, 1 septembre 2010 (2010-09-01), pages 2576-2589, XP011318684, ISSN: 0090-6778, DOI: 10.1109/TCOMM.2010.09.090436 cité dans la demande**

**EP 2 957 057 B1**

**Description**

<u>Arrière-plan de l'invention</u>

L'invention se rapporte au domaine général des télécommunications.

Elle concerne plus particulièrement une méthode de prédiction des performances d'un système de communications numériques.

L'invention s'applique de façon privilégiée mais non limitative dans le contexte d'un réseau de télécommunications sans fil, tel que par exemple un réseau LTE (Long Term Evolution) défini par le 3GPP (Third Group Partnership Project), dans lequel on envisage une adaptation des ressources utilisées par un émetteur, pour transmettre des données à destination d'un récepteur, en fonction de la qualité du lien radio entre l'émetteur et le récepteur (autrement dit, en fonction du canal de transmission séparant l'émetteur du récepteur et des performances, en termes notamment de probabilité d'erreur, pouvant être atteintes sur ce canal par le système). L'émetteur est par exemple un terminal mobile, et le récepteur, une station de base du réseau sans fil contrôlant la cellule dans laquelle se trouve le terminal mobile.

Les ressources utilisées par l'émetteur dépendent du niveau de protection que l'on souhaite apporter aux données transmises par l'émetteur à destination du récepteur. Ce niveau de protection varie en fonction du schéma de modulation et de codage ou MCS (Modulation and Coding Scheme) utilisé par l'émetteur : plus l'efficacité spectrale du schéma MCS est grande, plus la protection des données en résultant est faible, et donc plus la qualité du lien radio doit être bonne pour permettre une transmission fiable sur ce lien.

L'adaptation du lien radio consiste donc à adapter le débit instantané de la transmission à la qualité du canal en sélectionnant un schéma de modulation et de codage approprié pour l'émetteur pour chaque transmission.

Dans un réseau de télécommunications sans fil, cette adaptation s'appuie sur l'existence d'une voie de retour entre l'émetteur et le récepteur, généralement à débit limité. Elle comprend trois phases principales :

- l'émetteur envoie des symboles pilotes connus au récepteur ;
- le récepteur estime, à partir de ces symboles pilotes, la qualité du lien radio avec l'émetteur. Cette qualité du lien radio est représentative des performances attendues de l'émetteur dans les conditions de canal courantes. Le récepteur sélectionne, en fonction de cette qualité, un schéma MCS adapté au canal de transmission, et retourne à l'émetteur, via la voie de retour, une indication lui permettant d'identifier ce schéma MCS ;
- l'émetteur transmet des données au récepteur en utilisant le schéma MCS ainsi sélectionné.

La stratégie utilisée pour mettre en oeuvre l'adaptation du lien radio dépend de plusieurs facteurs, et notamment, du type de codage utilisé en émission, des caractéristiques instantanées du canal de transmission, du type d'égaliseur et du type de décodage utilisé en réception. Cette stratégie doit permettre une adaptation rapide et efficace de sorte à pouvoir être implémentée en temps réel dans le réseau de télécommunications, au niveau notamment de la couche MAC (Médium Access Layer), dans les mécanismes de prise de décisions et d'allocation de ressources aux terminaux.

Il existe dans l'état de la technique diverses stratégies permettant une adaptation rapide du lien radio lorsque ce lien est un canal à antennes multiples et à évanouissements par blocs, sélectif en temps et/ou en fréquence. Ces stratégies reposent sur une abstraction de la couche physique, et plus précisément sur une modélisation semi-analytique du comportement du récepteur. Cette modélisation est utilisée pour prédire les performances du système de transmission incluant l'émetteur et le récepteur, notamment en termes de probabilité d'erreur de transmission.

Le document de E. Ohlmer et G. Fettweis, intitulé « Link adaptation in linearly precoded closed-loop MIMO-OFDM systems with linear receivers », Proceedings IEEE ICC'09, Dresden, Germany, Juin 2009, propose une modélisation de la couche physique d'un système MIMO (Multiple Input Multiple Output) OFDM (Orthogonal Frequency Division Multiplexing) implémentant un récepteur linéaire.

Cette modélisation repose sur l'évaluation, en sortie du récepteur linéaire, d'un rapport signal sur interférence plus bruit (ou SINR pour Signal to Interference plus Noise Ratio) unique représentant la qualité du lien radio, et associé à un canal équivalent à bruit blanc additif gaussien (ou canal AWGN pour Additive White Gaussian Noise). Ce SINR unique résulte de la « compression » d'une pluralité de SINR dits intermédiaires disponibles en sortie du récepteur, selon une métrique dite de l'information mutuelle moyenne (ou MIESM pour Mutual Information Effective SINR Metric), décrite notamment dans le document de K. Brueninghaus et al. intitulé « Link performance models for system level simulations of broadband radio access systems », Proceedings IEEE PIMRC'05, Berlin, vol. 4, pp. 2306-2311, Septembre 2005.

Plus précisément, on détermine pour chaque SINR intermédiaire, à l'aide d'une table de correspondance préétablie (ou LUT pour look-up table), l'information mutuelle d'un canal AWGN équivalent à ce SINR intermédiaire. Puis sous l'hypothèse que les canaux AWGN équivalents associés aux SINR intermédiaires sont parallèles et indépendants, on évalue la moyenne des informations mutuelles ainsi déterminées.

L'information mutuelle moyenne en résultant est transformée en un SINR unique grâce à la table de correspondance préétablie. Ce SINR unique constitue une métrique de qualité du lien radio. Il peut alors être comparé à des courbes de probabilités d'erreurs élaborées pour divers schémas MCS en fonction du SINR, de sorte à sélectionner le schéma MCS qui présente la plus grande efficacité spectrale tout en respectant une probabilité d'erreur donnée.

D'autres modélisations de la couche physique ont été proposées pour des récepteurs plus complexes que des récepteurs linéaires, et notamment pour des récepteurs mettant en oeuvre dess techniques d'annulation successive de l'interférence.

Ainsi, le document de R. Visoz et al. (ci-après D1), intitulé « Semi-analytical performance prediction methods for iterative LMMSE-IC multiuser MIMO joint decoding », IEEE Transactions on Communications, vol. 58, no. 9, pp. 2576-2589, Septembre 2010, décrit une modélisation de la couche physique et une prédiction des performances, sur un canal à évanouissements par bloc sélectif en temps ou en fréquence, d'un système de communication MIMO multi-utilisateurs comprenant un émetteur utilisant un schéma MCS et un récepteur itératif non-linéaire mettant en oeuvre une technique itérative d'annulation successive de l'interférence.

Le schéma MCS envisagé dans D1 est une modulation codée entrelacée par bit (ou BICM pour Binary Interleaved Coded Modulation), et sa généralisation spatio-temporelle (aussi connue sous le nom de STBICM pour Space Time Bit Interleaved Coded Modulation) lorsque l'émetteur dispose d'une pluralité d'antennes d'émission et le récepteur une pluralité d'antennes de réception.

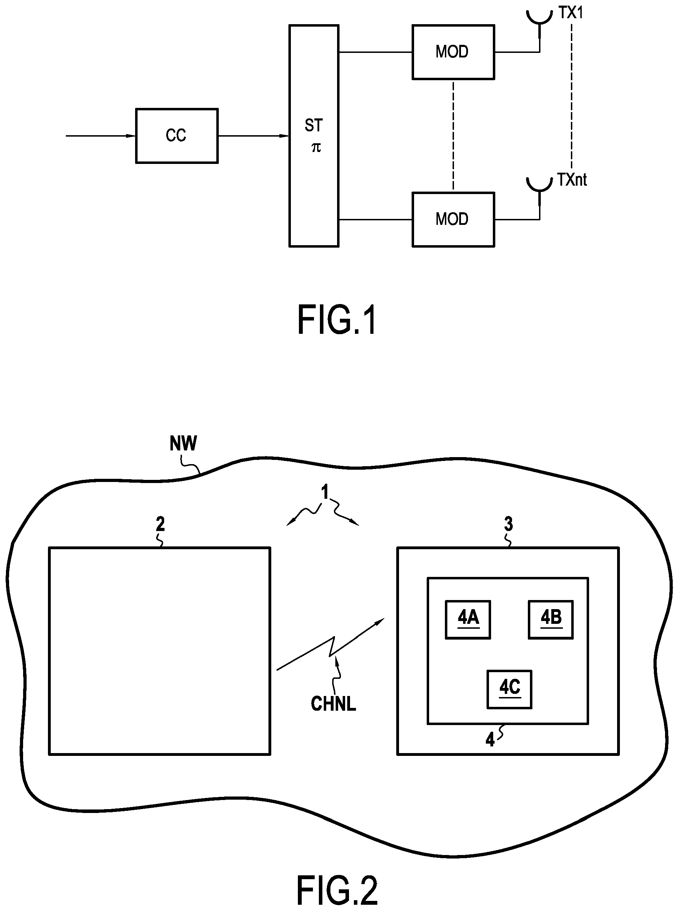

La **figure 1** illustre le schéma bien connu d'une modulation STBICM. Cette modulation se compose d'un code correcteur d'erreur binaire externe, en l'occurence un code convolutif CC binaire apte à coder une pluralité de bits d'information en bits codés, d'un entrelaceur spatio-temporel ST-$\Pi$ apte à entrelacer les bits codés sur une pluralité d'antennes d'émission, et d'un modulateur par antenne de transmission, apte à fournir des symboles d'une constellation donnée à partir des bits codés associés à chaque antenne d'émission. Aucune hypothèse n'est faite sur l'étiquetage employé par les modulateurs.

Le récepteur itératif comprend un détecteur multi-utilisateurs (i.e. un égaliseur), à savoir un détecteur LMMSE-IC (Linear Minimum Mean-Square Error Iterative Cancellation), qui alimente un banc de démodulateurs et de décodeurs SISO (Soft Input Soft Output) à entrées et à sorties souples (un démodulateur et un décodeur par utilisateur). Par entrées et sorties souples, on entend que les décodeurs SISO reçoivent en entrées des valeurs non binaires, telles que par exemple des quantités probabilistes, et délivrent également des sorties non binaires.

Chaque décodeur SISO implémente un algorithme BCJR (du nom de ses inventeurs, Bahl, Cocke, Jelinek et Raviv), qui optimise le critère du Maximum A Posteriori (MAP) bit à bit. Le détecteur multi-utilisateurs, les démodulateurs et les décodeurs s'échangent des informations souples sur les bits codés et les symboles de la modulation STBICM, à chaque itération du récepteur.

Plus précisément, lors de chaque itération $i$ du récepteur itératif, chaque décodeur SISO évalue à partir d'observations et de quantités probabilistes représentatives de probabilités *a priori* dont il dispose sur les bits codés associés aux symboles de la STBICM (fournies par le démodulateur), des quantités probabilistes représentatives de probabilités *a posteriori* sur ces bits codés. Ces probabilités *a posteriori* représentent les probabilités de transmission de ces bits codés. Dans D1, les quantités probabilistes reçues et fournies par chaque décodeur SISO sont des rapports logarithmiques de vraisemblance c'est-à-dire de probabilités ou LLR (Log Likelihood Ratio). Par souci de simplification, dans la suite de la description, on désigne par LAPPR des rapports logarithmiques de probabilités *a posteriori* et par LEXTPR des rapports logarithmiques de probabilités extrinsèques.

Les LAPPR estimées par le décodeur SISO sont utilisées d'une part, pour calculer une variance sur les symboles STBICM qui est ensuite fournie au détecteur multi-utilisateurs afin d'être utilisée par celui-ci à l'itération $i+1$ pour la détection des symboles STBICM, et d'autre part, pour calculer des LEXTPR sur les bits codés qui fournissent une mesure de la fiabilité des LAPPR.

Ces LEXTPR sont utilisées comme rapports logarithmiques de probabilités *a priori* sur les bits codés par le démodulateur associé à ce décodeur à l'itération $i+1$. Le démodulateur fournit à son tour des LEXTPR sur les bits codés au décodeur SISO, qui les utilise comme rapports logarithmiques de probabilités *a priori* sur les bits codés lors du décodage réalisé à l'itération $i+1$.

D1 propose une méthode de prédiction des performances de ce système de transmission, à chaque itération $i$ du récepteur itératif, qui s'appuie :

- sur une modélisation semi-analytique du comportement du détecteur multi-utilisateurs à l'aide d'un SINR résultant de la compression, selon la métrique MIESM, d'une pluralité de SINR calculés sur les symboles STBICM en sortie du détecteur, pour chaque antenne d'émission et pour chaque bloc du canal à évanouissements. Ces SINR dépendent de l'estimation du canal de transmission entre l'émetteur et le récepteur, d'une estimation de la variance du bruit (pouvant inclure aussi certaines sources d'interférences modélisées comme du bruit) et de la variance des symboles STBICM en entrée du détecteur ; et
- sur une modélisation conjointe du démodulateur et du décodeur SISO de chaque utilisateur, opérant sur les symboles STBICM délivrés en sortie du détecteur multi-utilisateurs, cette modélisation étant basée sur l'analyse de l'évolution de l'information mutuelle moyenne entre les bits codés associés à chaque symbole STBICM et les LEXTPR sur ces bits codés disponibles en sortie du décodeur SISO.

L'évolution de l'information mutuelle est déterminée en utilisant une table de correspondance tridimensionnelle, préétablie via des simulations Monte-Carlo, et qui donne pour une valeur donnée de l'information mutuelle moyenne entre les bits codés des symboles STBICM et les rapports logarithmiques de probabilités *a priori* sur ces bits codés en entrée du démodulateur, et pour une valeur donnée de l'information mutuelle moyenne associée au SINR compressé, une valeur de l'information mutuelle moyenne entre les bits codés des symboles STBICM et les LEXTPR sur ces bits codés disponibles en sortie du décodeur.

Il convient de noter que cette table de correspondance tridimensionnelle n'est plus nécessaire dès lors qu'un étiquetage de Gray est envisagé pour la modulation STBICM. Il n'est en effet plus nécessaire de suivre l'information mutuelle moyenne entre les bits codés et les rapports logarithmiques de probabilités *a priori* sur ces bits codés.

D1 propose également d'utiliser une table de correspondance similaire pour établir la probabilité d'erreur en sortie du décodeur à chaque itération du récepteur itératif, ainsi que la variance des symboles codés. La variance des symboles codés déterminée à l'itération *i* est utilisée à l'itération *i+1* pour estimer le SINR compressé. Il convient de noter que cette table de correspondance tridimensionnelle devient bidimensionnelle dès lors qu'un étiquetage de Gray est envisagé pour la modulation STBICM.

La méthode de prédiction proposée dans D1 permet d'estimer de façon précise et rapide les performances d'un système de communication utilisant en émission une modulation codée construite à partir d'un code convolutif simple, et s'appuyant en réception, sur un décodage optimal de ce code convolutif selon le critère MAP bit à bit.

Toutefois, elle ne convient pas lorsqu'on utilise en émission des modulations codées construites à partir de codes plus complexes tels que des codes composites, et notamment des turbo-codes.

En effet, un turbo-code est un code correcteur d'erreurs, basé sur la concaténation de plusieurs codes constituants élémentaires (typiquement deux), séparés par un entrelaceur. Les codes constituants sont par exemple des codes convolutifs récursifs et systématiques. Les turbo-codes sont connus pour leurs excellentes performances, et sont largement utilisés aujourd'hui dans les standards de télécommunications sans fil, et notamment dans le standard LTE.

Contrairement aux codes convolutifs, les turbo-codes sont, du fait de leur structure particulière, difficiles à décoder de façon optimale sur la base d'un critère MAP bit à bit, y compris pour des longueurs de codes assez réduites. Pour cette raison, on recourt en pratique à un décodage itératif sous-optimal, basé sur l'utilisation de décodeurs SISO élémentaires (associés respectivement aux codes constituants du turbo-code), qui s'échangent entre eux des quantités probabilistes à chaque itération de décodage.

On comprend bien dès lors que la modélisation envisagée dans D1 ne permet pas de prendre en compte l'utilisation d'un tel schéma de décodage itératif au niveau du récepteur.

Il existe donc un besoin d'une méthode de prédiction des performances d'un système de communication s'appuyant en émission sur une modulation STBICM construite à partir d'un turbo-code, et en réception, sur un récepteur itératif implémentant un détecteur mettant en oeuvre une annulation successive de l'interférence et un décodeur sous-optimal itératif.

Objet et résumé de l'invention

L'invention remédie notamment à ce besoin en proposant un procédé de prédiction des performances, sur un canal de transmission à entrées et à sorties multiples, d'un système de communication comprenant :

- un émetteur apte à appliquer sur des bits d'information, émis par une source, une modulation codée entrelacée par bit de sorte à générer des symboles codés, ces symboles codés étant transmis par l'émetteur sur le canal de transmission, cette modulation codée étant basée sur un turbo-code comprenant au moins deux codes constituants ; et
- un récepteur itératif, apte à mettre en oeuvre une technique itérative d'annulation d'interférence pour traiter les symboles codés reçus du canal de transmission, ce récepteur itératif comprenant un égaliseur, un démodulateur et un turbo-décodeur activés lors de chaque itération mise en oeuvre par le récepteur itératif, le turbo-décodeur comprenant au moins deux décodeurs permettant de décoder respectivement les codes constituants du turbo-code, ces décodeurs étant aptes à s'échanger de manière itérative des quantités probabilistes ;

le procédé de prédiction comprenant, pour chaque itération *i* du récepteur itératif :

- une première étape de détermination d'une valeur $\overline{\gamma}_{Eq}^{(i)}$ représentative d'un rapport signal sur interférence plus bruit en sortie de l'égaliseur, à partir d'une estimation du canal de transmission et d'une estimation v de la variance des symboles codés en entrée de l'égaliseur à l'itération *i*, cette détermination étant faite en utilisant une fonction préétablie caractérisant le comportement de l'égaliseur ; et

- une seconde étape de détermination :

   ○ d'une probabilité d'erreur de transmission $P_e(i)$ sur le canal ;
   ○ d'une variance $\overline{v}_i$ des symboles codés en sortie du turbo-décodeur ; et

   ○ d'une information mutuelle moyenne $I_{E,DEC}^{(i)}$ entre les bits d'information émis par la source et des quantités probabilistes représentatives de probabilités extrinsèques sur ces bits d'information fournies en sortie du turbo-décodeur ;

cette détermination se faisant à partir de la valeur $\overline{\gamma}_{Eq}^{(i)}$ et d'une information mutuelle moyenne $I_{A,DEC}^{(i)}$ dite *a priori* entre les bits d'information émis par la source et des quantités probabilistes représentatives de probabilités *a priori* sur ces bits d'information disponibles en entrée du turbo-décodeur à l'itération *i*, en utilisant des fonctions préétablies caractérisant le comportement du démodulateur et du turbo-décodeur pour un nombre prédéterminé d'itérations de décodage mises en oeuvre par le turbo-décodeur,

la variance $\overline{v}_i$ étant utilisée lors de la première étape de détermination, à l'itération suivante *i+1* du récepteur itératif, pour estimer la variance $\overline{v}$ des symboles codés en entrée de l'égaliseur, et l'information mutuelle moyenne $I_{E,DEC}^{(i)}$ étant utilisée lors de la seconde étape de détermination, à l'itération *i+1,* comme information mutuelle moyenne *a priori* $I_{A,DEC}^{(i+1)}$.

Corrélativement, l'invention vise également un dispositif de prédiction des performances, sur un canal de transmission, d'un système de communication comprenant :

- un émetteur apte à appliquer sur des bits d'information, émis par une source, une modulation codée entrelacée par bit de sorte à générer des symboles codés, ces symboles codés étant transmis par l'émetteur sur le canal de transmission, cette modulation codée étant basée sur un turbo-code comprenant au moins deux codes constituants ; et
- un récepteur itératif, apte à mettre en oeuvre une technique itérative d'annulation d'interférence pour traiter les symboles codés reçus du canal de transmission, ce récepteur itératif comprenant un égaliseur, un démodulateur et un turbo-décodeur activés lors de chaque itération mise en oeuvre par le récepteur itératif, le turbo-décodeur comprenant au moins deux décodeurs permettant de décoder respectivement les codes constituants du turbo-code, ces décodeurs étant aptes à s'échanger de manière itérative des quantités probabilistes ;

ce dispositif comprenant un module apte à activer pour chaque itération *i* du récepteur itératif :

- un premier module de modélisation, apte à déterminer une valeur $\overline{\gamma}_{Eq}^{(i)}$ représentative d'un rapport signal sur interférence plus bruit en sortie de l'égaliseur, à partir d'une estimation du canal de transmission et d'une estimation $\overline{v}$ de la variance des symboles codés en entrée de l'égaliseur à l'itération *i*, cette détermination étant faite en utilisant une fonction préétablie caractérisant le comportement de l'égaliseur ; et
- une second module de modélisation, apte à déterminer :

   ○ d'une probabilité d'erreur de transmission $P_e(i)$ sur le canal ;
   ○ d'une variance $\overline{v}_i$ des symboles codés en sortie du turbo-décodeur ; et

   ○ d'une information mutuelle moyenne $I_{E,DEC}^{(i)}$ entre les bits d'information émis par la source et des quantités probabilistes représentatives de probabilités extrinsèques sur ces bits d'information fournies en sortie du turbo-décodeur (c'est-à-dire à l'issue de la dernière activation du dernier décodeur du turbo-décodeur) ;

cette détermination se faisant à partir de la valeur $\overline{\gamma}_{Eq}^{(i)}$ et d'une information mutuelle moyenne $I_{A,DEC}^{(i)}$ dite *a priori* entre les bits d'information émis par la source et des quantités probabilistes représentatives de probabilités *a priori* sur ces bits d'information disponibles en entrée du turbo-décodeur à l'itération *i*, le second module de modélisation utilisant des fonctions préétablies caractérisant le comportement du démodulateur et du turbo-décodeur pour un nombre prédéterminé d'itérations de décodage mises en oeuvre par le turbo-décodeur,

la variance $\bar{v}_i$ étant utilisée par le premier module de modélisation, à l'itération suivante $i+1$ du récepteur itératif, pour estimer la variance $\bar{v}$ des symboles codés en entrée de l'égaliseur, et l'information mutuelle moyenne $I_{E,DEC}^{(i)}$ étant utilisée par le second module de modélisation, à l'itération $i+1$, comme information mutuelle moyenne *a priori* $I_{A,DEC}^{(i+1)}$.

Chaque itération de décodage mise en oeuvre par le turbo-décodeur correspond à l'activation de chacun des décodeurs du turbo-décodeur.

Par quantités probabilistes on entend indifféremment au sens de l'invention des probabilités ou des densités de probabilités sur des symboles et/ou des bits, ou encore des rapports logarithmiques de vraisemblance de probabilités ou densités de probabilités (aussi connues sous le nom de LLR).

L'invention propose ainsi une méthode de prédiction efficace et rapide permettant d'estimer les performances d'un système de communication s'appuyant sur une modulation codée basée sur un turbo-code (BICM ou STBICM) et mettant en oeuvre un récepteur itératif utilisant une technique itérative d'annulation de l'interférence et intégrant un décodeur sous-optimal itératif du turbo-code. Elle vient compléter par là-même la modélisation proposée dans D1 qui ne permet pas d'adresser l'utilisation de turbo-code en émission et d'un décodeur itératif en réception.

Il convient de noter que l'interférence que cherche à éliminer le récepteur itératif peut être de différentes natures : il peut s'agir d'interférence liée à la présence de trajets multiples dans le canal ou à l'utilisation d'antennes multiples multi-antennes, ou d'interférence multi-utilisateurs, etc.

La méthode de prédiction selon l'invention s'appuie :

- d'une part, sur une modélisation du comportement de l'égaliseur par le biais d'un rapport SINR unique associés aux symboles codés en sortie de l'égaliseur, et
- d'autre part, sur une modélisation conjointe du démodulateur et du décodeur sous-optimal itératif du turbo-code (turbo-décodeur). A cette fin, et pour prendre en compte la spécificité du turbo-décodeur, l'invention propose avantageusement de suivre l'évolution de l'information mutuelle moyenne relative aux quantités probabilistiques extrinsèques qui sont disponibles en sortie du turbo-décodeur sur les bits d'information émis par la source, autrement dit, et étant donnée la structure du turbo-décodeur, l'information mutuelle moyenne relative aux quantités probabilistes extrinsèques délivrées en sortie du dernier décodeur du turbo-décodeur (i.e. fournies par le deuxième décodeur pour un turbo-code à deux niveaux) et qui permettent de décoder le premier code constituant du turbo-code à la prochaine itération « globale » du récepteur. Une itération globale correspond à l'activation du détecteur (soustraction d'interférence et filtrage) et du turbo décodeur, celui-ci pouvant lui-même inclure plusieurs itérations internes de décodage.

Un tel suivi permet de caractériser de façon fiable le comportement du démodulateur et du turbo-décodeur tout en tenant compte de leurs spécificités et notamment des informations probabilistiques qui s'échangent entre ces entités.

Afin de proposer une méthode de prédiction simple et rapide pouvant être utilisée en temps réel et être embarquée sur un récepteur tel un terminal, la modélisation du comportement de l'égaliseur est réalisée via une fonction préétablie, qui permet à partir d'une estimation du canal de transmission et de l'estimation $\bar{v}$ de la variance des symboles codés en entrée de l'égaliseur, de déterminer un rapport signal sur interférence plus bruit $\bar{\gamma}_{Eq}^{(i)}$ ou SINR en sortie de l'égaliseur.

Pour certains égaliseurs, et notamment pour un égaliseur de type LMMSE-SIC, cette fonction peut, de façon avantageuse, être définie analytiquement ou semi-analytiquement.

Ainsi, par exemple, lorsque l'égaliseur est un détecteur LMMSE-SIC, le canal de transmission est un canal MIMO à évanouissements par bloc comprenant $nb$ de blocs, l'émetteur émet les symboles codés sur $nt$ antennes d'émission, la première étape de détermination comprend :

- une étape d'estimation d'un rapport signal sur interférence plus bruit $\gamma_{b;t}^{(i)}$ en sortie de l'égaliseur pour chaque bloc $b$ du canal à évanouissement et pour chaque antenne td'émission de l'émetteur à l'aide d'une fonction préétablie $\Phi_{b;t}$ ; et

- une étape d'estimation, pour chaque rapport signal sur interférence plus bruit $\gamma_{b;t}^{(i)}$ d'une information mutuelle moyenne $I_{LE_{b;t}}^{(i)}$ d'un canal à bruit blanc additif gaussien de variance $1/\gamma_{b;t}^{(i)}$ (pour une puissance des symboles normalisée à 1), en utilisant une fonction $\psi$ inversible préétablie ;

la valeur $\overline{\gamma}_{Eq}^{(i)}$ étant déterminée selon l'équation suivante :

$$\overline{\gamma}_{Eq}^{(i)} = \psi^{-1}\left(\frac{1}{n_b n_t}\sum_{b=1}^{n_b}\sum_{t=1}^{n_t}I_{LE_{b;t}}^{(i)}\right)$$

La fonction $\psi$ dépend de la modulation codée utilisée en émission.

Ainsi, en d'autres mots, dans ce mode particulier de réalisation, $\overline{\gamma}_{Eq}^{(i)}$ est un SINR compressé selon la métrique MIESM à partir des SINR de chaque antenne d'émission et chaque bloc du canal de transmission. Ces SINR pour chaque antenne d'émission et chaque bloc du canal de transmission sont estimés à l'aide d'une fonction $\Phi_{b;t}$ prédéterminée qui dépend de l'estimation du canal MIMO correspondant au bloc $b$ et à l'antenne $t$ et de la variance du bruit sur ce canal.

En variante, pour d'autres égaliseurs, on peut envisager d'établir les fonctions $\Phi_{b;t}$ et $\psi$ par simulation Monte Carlo s'il est difficile d'établir de façon semi-analytique une quantité équivalente à un rapport signal sur interférence sur bruit $\overline{\gamma}_{Eq}^{(i)}$ unique en sortie de l'égaliseur.

La fonction $\psi$ permettant de calculer l'information mutuelle dans le mode de réalisation décrit ci-dessus, peut être stockée sous la forme d'une table de correspondance ou LUT (pour Look-Up Table) bidimensionnelle de sorte à accélérer l'exécution du procédé de prédiction selon l'invention.

De plus, une formule analytique approchée pour $\Phi_{b;t}$ peut être avantageusement utilisée pour obtenir rapidement une estimation du SINR $\gamma_{b;t}^{(i)}$. Cette fonction dépend en effet de nombreuses variables scalaires, de sorte qu'il est préférable d'utiliser une telle approximation plutôt que de faire appel à une table de correspondance.

Comme mentionné précédemment, la modélisation conjointe du comportement du démodulateur et du turbo-décodeur repose sur l'utilisation de fonctions préétablies qui dépendent de deux variables, à savoir le SINR $\overline{\gamma}_{Eq}^{(i)}$ et l'information mutuelle moyenne relative à des quantités probabilistiques représentatives de probabilités *a priori* sur les bits d'information disponibles en entrée du turbo-décodeur, autrement dit en entrée du premier décodeur du turbo-décodeur.

Par le biais de la modélisation de l'égaliseur itératif externe et de la modélisation conjointe du démodulateur et du turbo-décodeur, l'invention permet de suivre l'évolution de deux entités dynamiques imbriquées au niveau du récepteur itératif qui s'échangent à chaque itération du récepteur itératif des informations souples. Les échanges entre ces deux entités sont également modélisés conformément à l'invention d'une part, via le SINR $\overline{\gamma}_{Eq}^{(i)}$ issu de la première étape de détermination et utilisé lors de la deuxième étape de détermination, et d'autre part via la variance $\overline{v}_i$ des symboles codés issue de la deuxième étape de détermination et utilisée lors de la première étape de détermination à l'itération suivante.

L'évolution de l'égaliseur itératif externe est ainsi analysée à travers l'évolution de la variance des symboles codés, tandis que l'évolution du démodulateur et du turbo-décodeur est analysée à travers l'évolution de l'information mutuelle moyenne sur les quantités probabilistiques extrinsèques fournies en sortie du turbo-décodeur, qui est ensuite utilisée comme information mutuelle moyenne sur des quantités probabilistiques *a priori* à l'itération suivante.

Dans un mode de réalisation de l'invention :

- la fonction préétablie caractérisant le comportement de l'égaliseur est mémorisée sous forme d'une table de correspondance bidimensionnelle ;
- les fonctions préétablies caractérisant le comportement conjoint du démodulateur et du turbo-décodeur sont mémorisées sous forme de tables de correspondance tridimensionnelles.

Par ailleurs, comme mentionné précédemment, pour un détecteur de type LMMSE-SIC, les fonctions $\Phi_{b;t}$ représentent le SINR en sortie du détecteur après soustraction de l'interférence pour chaque bloc $b$ du canal à évanouissement et chaque antenne $t$ de l'émetteur, peuvent être définies analytiquement.

De cette sorte, il suffit de lire les tables de correspondance pour obtenir une estimation du $\mathrm{SINR}\,\overline{\gamma}_{Eq}^{(i)}$, de la probabilité d'erreur $P_e(i)$, de la variance $\overline{v}_i$ et de l'information mutuelle moyenne $I_{E,DEC}^{(i)}$. Une telle lecture est très rapide. La mise en oeuvre de l'invention requiert ainsi peu de capacités de calcul et de traitement, et s'appuie essentiellement sur une capacité de stockage des tables de correspondance.

Dans un mode particulier de réalisation de l'invention, la fonction utilisée pour déterminer la variance $\overline{v}_i$ est préétablie en supposant que la variance des symboles codés en sortie du turbo-décodeur est estimée par le récepteur itératif à partir de quantités probabilistiques représentatives de probabilités *a posteriori* fournies par le turbo-décodeur sur les bits codés.

Ce mode de réalisation s'attache à la prédiction de performances d'un système de communication s'appuyant sur un récepteur itératif au sein duquel le turbo-décodeur fournit des quantités probabilistiques représentatives de probabilités *a posteriori,* telles que des LAPPR, pour estimer la variance des symboles à l'itération suivante en entrée de l'égaliseur.

Dans un autre mode de réalisation, la fonction utilisée pour déterminer la variance $\overline{v}_i$ est préétablie en supposant que la variance des symboles codés en sortie du turbo-décodeur est estimée par le récepteur itératif à partir de quantités probabilistiques représentatives de probabilités extrinsèques fournies par le turbo-décodeur sur les bits codés.

Ce mode de réalisation s'attache quant à lui à la prédiction de performances d'un système de communication s'appuyant sur un récepteur itératif au sein duquel le turbo-décodeur fournit des quantités probabilistiques représentatives de probabilités extrinsèques, telles que des LEXTPR, pour estimer la variance des symboles à l'itération suivante en entrée de l'égaliseur.

En fait, il a été récemment mis en évidence qu'un récepteur itératif d'un système de communication multi-antennes ou multiutilisateurs, qui se base sur une variance des symboles codés estimée à partir de LAPPR fournies par le turbo-décodeur, présente de meilleures performances, dans des conditions où les interférences sont importantes (ex. pour des MCS à forts rendements, et/ou une interférence entre symboles sévère, et/ou un canal chargé spatialement c'est-à-dire pour lequel le nombre d'antennes d'émission est supérieur au nombre d'antennes de réception), qu'un récepteur itératif qui se base sur une variance des symboles codés estimée à partir de LEXTPR fournies par le turbo-décodeur. Ceci s'explique en partie parce que l'utilisation de LAPPR plutôt que des LEXTPR conduit à une plus grande fiabilité des symboles estimés par l'égaliseur dans de tels scénarii : l'information supplémentaire obtenue par l'égaliseur par le biais des LAPPR lui permet d'annuler davantage d'interférence à chaque itération.

Toutefois, l'utilisation de quantités probabilistiques de type *a posteriori* plutôt qu'extrinsèques conduit à adopter certaines hypothèses (notamment d'indépendance de certaines quantités probabilistiques) lors de la modélisation des entités du récepteur itératif selon l'invention qui ne sont pas vérifiées en pratique. Il s'ensuit que certaines imprécisions dans la prédiction des performances peuvent être rencontrées sous certaines hypothèses, résultant en une probabilité d'erreur prédite conformément à l'invention inférieure à la probabilité d'erreur réelle du système de communication obtenue par simulation.

Pour remédier à cet inconvénient, lorsque la fonction utilisée pour déterminer la variance $\overline{v}_i$ est préétablie en supposant que la variance des symboles codés en sortie du turbo-décodeur est estimée par le récepteur itératif à partir de quantités probabilistiques représentatives de probabilités *a posteriori* fournies par le turbo-décodeur sur les bits codés, la variance des symboles codés en entrée de l'égaliseur à l'itération *i+1* est estimée selon :

$$\overline{v} = \min(\beta\overline{v}^{(i)},1)$$

où $\beta$ désigne un facteur de pondération.

Les inventeurs ont constaté qu'une telle pondération permet de corriger efficacement la probabilité d'erreur prédite de sorte à la rendre très proche de la probabilité obtenue par simulation.

Des simulations exhaustives conduites par les inventeurs ont par ailleurs montré que ce facteur de pondération dépend du schéma de codage et de modulation envisagé en émission, mais ne varie pas en revanche significativement en fonction du nombre d'antennes de transmission et/ou de réception ni des caractéristiques du canal (sélectivité en temps et/ou en fréquence).

Différents critères peuvent être envisagés pour choisir ce facteur de pondération $\beta$.

Ainsi, par exemple, il peut être choisi de sorte à minimiser la somme sur l'ensemble des itérations mises en oeuvre par le récepteur itératif et sur un grand nombre K de réalisations du canal de transmission, de distances évaluées entre la probabilité d'erreur estimée lors de la seconde étape de détermination et une probabilité d'erreur obtenue par simulation des performances du système de transmission pour ces itérations et ces réalisations du canal de transmission.

En variante, le facteur de pondération $\beta$ peut être choisi de sorte à minimiser pour une itération déterminée du récepteur itératif la somme sur un grand nombre K de réalisations du canal de transmission de distances évaluée entre la probabilité d'erreur estimée lors de la seconde étape de détermination et une probabilité d'erreur obtenue par simulation des performances du système de transmission pour ces réalisations du canal de transmission et cette itération déterminée.

Il convient de noter que lorsque la variance utilisée par l'égaliseur est estimée à partir de LEXTPR ou de quantités probabilistiques équivalentes sur les bits codés fournies par le turbo-décodeur, une telle calibration devient négligeable voire inutile.

Les performances globales du système de communication sont données par les probabilités d'erreur estimées à chaque itération.

Dans un mode de réalisation de l'invention, la probabilité d'erreur $P_e(i)$, la variance $\overline{v}_i$ et l'information mutuelle $I_{E,DEC}^{(i)}$ sont déterminées après une itération de décodage du turbo-décodeur.

Les inventeurs ont en effet constaté qu'une itération de décodage du turbo-décodeur permet d'optimiser les performances d'un récepteur itératif mettant en oeuvre une soustraction de l'interférence pour un nombre suffisamment élevé d'itérations globales de ce récepteur itératif.

Cependant pour des raisons de contraintes de délais, il est également possible, en variante, d'itérer plusieurs fois à l'intérieur du turbodécodeur avant de passer à la soustraction d'interférence..

Ainsi, selon cette variante, la probabilité d'erreur $P_e(i)$, la variance $\overline{v}_i$ et l'information mutuelle $I_{E,DEC}^{(i)}$ sont déterminées après une pluralité d'itérations de décodage du turbo-décodeur. Il suffit alors de considérer $I_{E,DEC}^{(i)}$ à la dernière itération des itérations internes du turbo code.

Dans un mode particulier de réalisation de l'invention, la modulation codée entrelacée par bit est basée sur un étiquetage de Gray. De cette sorte on obtient une modélisation du comportement du démodulateur simplifiée. Par ailleurs, ce mode de réalisation présente des avantages connus de l'homme du métier pour les canaux de transmission sans fil.

Dans un mode particulier de réalisation, les différentes étapes du procédé prédiction sont déterminées par des instructions de programmes d'ordinateurs.

En conséquence, l'invention vise aussi un programme d'ordinateur sur un support d'informations, ce programme étant susceptible d'être mis en oeuvre dans un dispositif de prédiction ou plus généralement dans un ordinateur, ce programme comportant des instructions adaptées à la mise en oeuvre des étapes d'un procédé de prédiction tel que décrit ci-dessus.

Ce programme peut utiliser n'importe quel langage de programmation, et être sous la forme de code source, code objet, ou de code intermédiaire entre code source et code objet, tel que dans une forme partiellement compilée, ou dans n'importe quelle autre forme souhaitable.

L'invention vise aussi un support d'informations lisible par un ordinateur, et comportant des instructions d'un programme d'ordinateur tel que mentionné ci-dessus.

Le support d'informations peut être n'importe quelle entité ou dispositif capable de stocker le programme. Par exemple, le support peut comporter un moyen de stockage, tel qu'une ROM, par exemple un CD ROM ou une ROM de circuit microélectronique, ou encore un moyen d'enregistrement magnétique, par exemple une disquette (floppy disc) ou un disque dur.

D'autre part, le support d'informations peut être un support transmissible tel qu'un signal électrique ou optique, qui peut être acheminé via un câble électrique ou optique, par radio ou par d'autres moyens. Le programme selon l'invention peut être en particulier téléchargé sur un réseau de type Internet.

Alternativement, le support d'informations peut être un circuit intégré dans lequel le programme est incorporé, le circuit étant adapté pour exécuter ou pour être utilisé dans l'exécution du procédé en question.

Selon un autre aspect, l'invention vise un système de communication comprenant :

- un émetteur apte à appliquer sur des bits d'information, émis par une source, une modulation codée entrelacée par bit de sorte à générer des symboles codés, ces symboles codés étant transmis par l'émetteur sur le canal de transmission, cette modulation codée étant basée sur un turbo-code comprenant au moins deux codes constituants ; et
- un récepteur itératif, apte à mettre en oeuvre une technique itérative d'annulation d'interférence pour traiter les symboles codés reçus du canal de transmission, ce récepteur itératif comprenant un égaliseur, un démodulateur et un turbo-décodeur activés lors de chaque itération mise en oeuvre par le récepteur itératif, le turbo-décodeur comprenant au moins deux décodeurs permettant de décoder respectivement les codes constituants du turbo-code, ces décodeurs étant aptes à s'échanger de manière itérative des quantités probabilistes ;

ce récepteur itératif comprenant en outre un dispositif de prédiction selon l'invention.

Le système de communication selon l'invention bénéficie des mêmes avantages cités précédemment que le procédé et le dispositif de prédiction.

Comme mentionné précédemment, une application privilégiée mais non limitative de l'invention vise l'adaptation du lien radio dans un réseau de télécommunications sans fil.

Ainsi, l'invention vise également l'utilisation d'un procédé de prédiction des performances selon l'invention dans un procédé d'adaptation du lien radio mis en oeuvre par un système de communication comprenant un émetteur et un récepteur itératif, ce procédé d'adaptation comprenant la sélection d'une modulation codée entrelacée par bit basée sur un turbo-code parmi un ensemble prédéterminé de schémas de codage et de modulation disponibles à l'émetteur, en fonction de la probabilité d'erreur déterminée par le procédé de prédiction pour cette modulation codée entrelacée par bit à une itération prédéterminée du récepteur itératif.

On peut également envisager, dans d'autres modes de réalisation, que le procédé de prédiction, le dispositif de prédiction, le système de communication et le procédé d'adaptation du lien radio selon l'invention présentent en combinaison tout ou partie des caractéristiques précitées.

Brève description des dessins

D'autres caractéristiques et avantages de la présente invention ressortiront de la description faite ci-dessous, en référence aux dessins et annexes qui en illustrent des exemples de réalisation dépourvus de tout caractère limitatif.

Sur les figures :

- la figure 1, déjà décrite, représente, de façon schématique, une modulation STBICM basé sur un code convolutif ;
- la figure 2 représente un système de communication selon l'invention comprenant un émetteur et un récepteur comportant un dispositif de prédiction selon l'invention, dans un mode particulier de réalisation ;
- la figure 3 représente le schéma de modulation et de codage utilisé par l'émetteur de la figure 2;
- la figure 4 représente la structure, au niveau couche physique, du récepteur de la figure 2 ;
- la figure 5 illustre l'architecture fonctionnelle du dispositif de prédiction de la figure 2 ;
- la figure 6 représente, sous forme schématique, l'architecture matérielle du récepteur de la figure 2 ;
- la figure 7 représente, sous forme d'ordinogramme, les principales étapes d'un procédé de prédiction selon l'invention dans un mode particulier de réalisation dans lequel il est mis en oeuvre par le dispositif de prédiction de la figure 4 ;
- les figures 8 et 9 illustrent la validation expérimentale du procédé de prédiction selon l'invention pour deux schémas de modulation et de codage distincts ;
- les figures 10 et 11 illustrent des tables de correspondance tridimensionnelles pouvant être utilisées au cours du procédé de prédiction selon l'invention ; et
- la figure 12 représente un procédé d'adaptation du lien radio entre l'émetteur et le récepteur de la figure 2 à l'aide d'un procédé de prédiction selon l'invention.

Sur les Annexes :

- l'Annexe 1 résume les principales étapes mises en oeuvre pour l'établissement des tables de correspondance utilisées au cours du procédé de prédiction selon l'invention ; et
- l'Annexe 2 rappelle les principales étapes mises en oeuvre pour simuler les performances du système de communication de la figure 2.

Description détaillée de l'invention

La **figure 2** représente, dans son environnement, un système de communication 1 conforme à l'invention, opérant dans un réseau de télécommunications sans fil NW, dans un mode particulier de réalisation.

Aucune limitation n'est attachée à la nature du réseau NW ni aux techniques de transmission mises en oeuvre sur ce réseau (ex. transmission mono-porteuse ou multi-porteuses, etc). Il peut s'agir d'un réseau LTE, UMTS (Universal Mobile Telecommunication System), etc.

Le système de communication 1 comprend un émetteur 2 et un récepteur 3, tous deux équipés d'antennes multiples. Dans l'exemple envisagé ici, l'émetteur 2 est un terminal mobile ayant $n_t$ antennes d'émission, et le récepteur 3 est une station de base du réseau de télécommunications NW ayant $n_r$ antennes de réception. L'invention est ainsi appliquée selon cet exemple à la prédiction des performances du système de communication 1 dans le sens montant (ou « uplink » en anglais).

Cette hypothèse n'est toutefois pas limitative et l'invention peut également s'appliquer à la prédiction de performances dans le sens descendant (ou « downlink » en anglais), pour des transmissions émises par la station de base (alors considérée comme émetteur au sens de l'invention) à destination du terminal mobile (alors considéré comme récepteur au sens de l'invention).

Nous allons maintenant décrire en détails le fonctionnement de l'émetteur 2 et du récepteur 3. Les notations suivantes sont utilisées :

- les lettres en caractères gras désignent des matrices ou des vecteurs ;
- si **A** est une matrice, la k-ième colonne de **A** est notée $\mathbf{a}_k$. L'entrée $(i, j)$ de **A** est notée $a_{i,j}$ ou $[\mathbf{A}]_{i,j}$ ;
- $\mathbf{0}_n$ désigne un vecteur nul de taille $n$ ;
- $\mathbf{I}_n$ est la matrice identité de dimensions $n \times n$ (i.e. à $n$ lignes et $n$ colonnes) ;
- les exposants *, T and † désignent respectivement l'opérateur de conjugaison complexe, l'opérateur de transposition et l'opérateur hermitien ;
- une variable aléatoire discrète $X$ a une fonction de probabilité de masse (« probability mass function (pmf) » en anglais) $P(X)$ ;
- une variable aléatoire continue $x$ a une fonction de densité de probabilité (« probability density function (pdf) » en anglais $p_X(x)$ ;
- $N_C(m,v)$ désigne une fonction de densité de probabilité complexe Gaussienne circulaire symétrique de moyenne $m$ et de variance $v$ ; $N_C(\mathbf{m}, \mathbf{V})$ désigne une fonction de densité de probabilité multidimensionnelle complexe Gaussienne circulaire symétrique de vecteur moyen $\mathbf{m}$ et de matrice de covariance $\mathbf{V}$ .

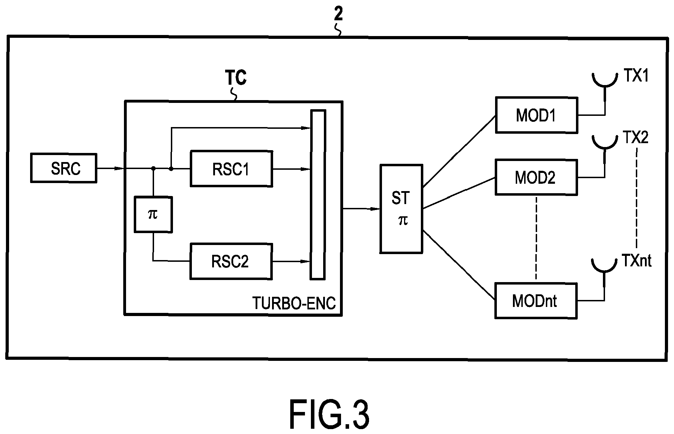

Dans l'exemple envisagé ici, et comme illustré à la **figure 3,** l'émetteur 2 met en oeuvre une modulation codée à entrelacement spatio-temporel binaire ou STBICM, basée sur un turbo-code TC parallèle comprenant deux codes constituants RSC1 et RSC2, séparés par un entrelaceur binaire $\Pi$.

Les codes constituants RSC1 et RSC2 sont ici des codes convolutifs systématiques récursifs de rendement ½, connus en soi.

Toutefois, aucune limitation n'est attachée au rendement du turbo-code ni à celui de ses codes constituants, ni même au nombre de codes constituants utilisés dans le turbo-code : on peut ainsi par exemple envisager de poinçonner la sortie du turbo-code pour obtenir un rendement de codage déterminé, d'utiliser des codes constituants de rendements différents de ½, ou encore d'utiliser d'autres codes constituants ou en nombre plus important, etc.

Un vecteur de $n_d$ bits d'informations, noté $\mathbf{u} \in \mathsf{F}_2^{n_d}$ (avec $\mathsf{F}_2 = GF(2)$), est émis par une source SRC et fourni en entrée d'un turbo-codeur TURBO-ENC, implémentant le turbo-code TC. Le mot de code généré à partir du vecteur $\mathbf{u}$ par le turbo-codeur est un vecteur $\mathbf{c} \in \mathsf{F}_2^{n_c}$ de dimension $n_c$.

Du fait de la structure du turbo-code TC, ce mot de code est composé des bits d'information émis par la source SRC, et des bits codés générés selon chaque code RSC1 et RSC2.

Par abus de langage dans la suite de la description, les notations RSC1 et RSC2 sont utilisés indifféremment pour désigner les codes constituants du turbo-code TC ou les codeurs du turbo-code TURBO-ENC implémentant ces codes constituants.

Les bits codés du mot de code **c** sont ensuite entrelacés sur les $nt$ antennes de l'émetteur 2 par un entrelaceur binaire spatio-temporel ST-$\Pi$, qui les réorganise en une matrice **D** de dimensions $n_t \times n_{cu}$, $n_{cu}$ désignant le nombre d'utilisations du canal, supposé fixe pour chaque transmission. Chaque entrée de cette matrice est une séquence de $q$ bits, $q$ étant un nombre entier prédéterminé dépendant de la constellation utilisée par la modulation, autrement dit,

$$\mathbf{D} \in \mathbb{Z}_{2^q}^{n_t \times n_{cu}}.$$

Puis, pour chaque antenne d'émission TXn, n=1,... $n_t$, un modulateur MODn transforme les bits codés associés à cette antenne en symboles dits codés d'une constellation complexe C prédéterminée. C est par exemple une constellation de symboles MDP-4 (Modulation par déplacement de phase à 4 états ou QPSK (Quadrature Phase Shift Keying)), MAQ-16 (Modulation d'Amplitude en Quadrature à 16 états ou QAM-16 (Quadrature Amplitude Modulation)), etc.), MAQ-64, etc. Dans le mode de réalisation décrit, on suppose que chaque modulateur applique un étiquetage de Gray désigné par $\mu$.

L'étiquetage de Gray $\mu$ et la constellation C de cardinal $2^q$ mis en oeuvre par chaque modulateur MOD1,..., MOD$n_t$, résultent en la transformation de la matrice **D** en une matrice complexe **S** de dimensions $n_t \times n_{cu}$

Dans la suite de la description, $C_j^{(0)}$ et $C_j^{(1)}$ désignent les sous-ensembles de points de la constellation C dont les étiquettes (i.e. séquence de q bits associées aux symboles de la constellation) ont un 0 ou un 1 à la position j.

On note par ailleurs $\mu_j^{-1}(s)$ la valeur de j-ième bit de l'étiquette d'un point quelconque s de la constellation C.

Il convient de noter que, lorsqu'une technique de type adaptation de lien est mise en oeuvre au niveau de l'émetteur 2, du fait de l'existence d'une voie de retour limitée entre l'émetteur 2 et le récepteur 3, seul un nombre fini de schémas de modulation et de codage (MCS) sont disponibles à l'émetteur 2. Ces schémas se définissent par divers paramètres, comme par exemple le type de codage mis en oeuvre (ex. turbo-code), le rendement des codes utilisés, le cas échéant, le taux et les motifs de poinçonnage mis en oeuvre en sortie du turbo-codeur, les constellations de modulation, etc.

Les symboles codés sont ensuite émis via les $n_t$ antennes d'émission de l'émetteur 2 sur un canal CHNL de transmission à entrées et à sorties multiples (canal MIMO). Dans l'exemple envisagé ici, le canal CHNL est un canal sélectif en fréquence (i.e. à trajets multiples), à évanouissements par bloc, et à bruit blanc additif gaussien (AWGN).

On désigne par $n_b$ le nombre de blocs d'évanouissement du canal. Chaque bloc est supposé constant sur $n_s = n_{cu}/n_b$ utilisations du canal.

Le canal de transmission CHNL peut être modélisé, de façon connue en soi, par un ensemble $\mathcal{H}$ de $n_b$ réponses impulsionnelles finies $\mathbf{H}_b(l)$, $b=1,...,n_b$ décrivant les variations rapides du canal dus aux évanouissements multi-trajets (small-scale fading) :

$$\mathbf{H}_b(l) = \sum_{\tau=0}^{n_\tau} \mathbf{H}_{b,\tau}\delta(l - \tau) \quad (1)$$

où $n_\tau$ désigne le nombre de trajets du canal. Chaque matrice de gains $\mathbf{H}_{b,\tau}$ est une matrice aléatoire de dimensions $n_r \times n_t$ et dont les entrées sont des variables aléatoires complexes gaussiennes circulaires, indépendantes et identiquement distribuées (i.i.d.), de moyenne nulle et de variance $\sigma_{b,\tau}^2$ avec $\sum_{\tau=0}^{n_\tau} \sigma_{b,\tau}^2 = 1$.

Par souci de simplification, on néglige ici la corrélation pouvant exister entre les antennes d'émission et/ou de réception.

Le canal de transmission introduit également un bruit blanc additif gaussien de moyenne nulle.

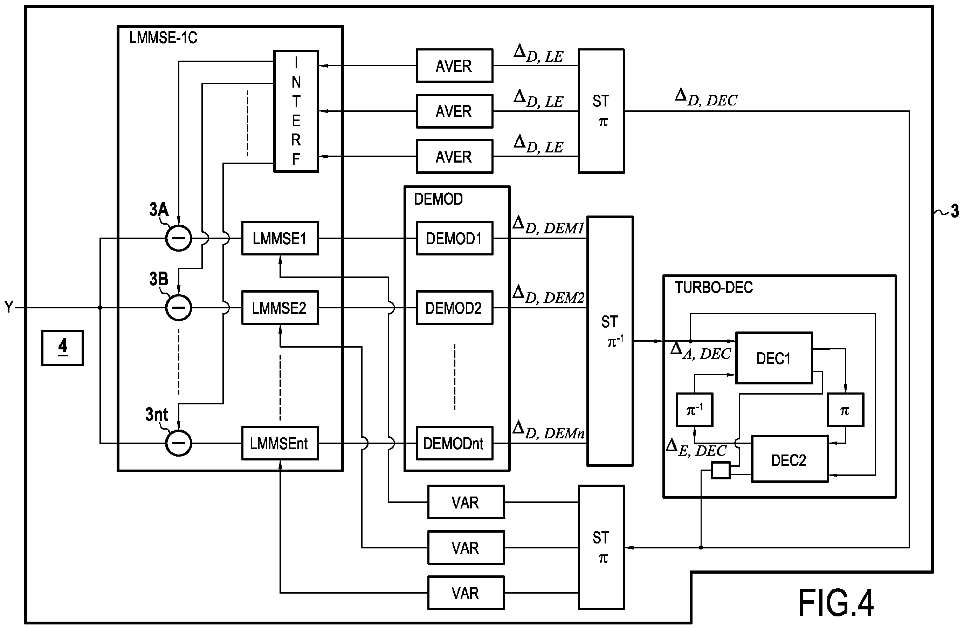

Les symboles codés transmis sur le canal CHNL sont reçus par les antennes de réception du récepteur 3. La structure du récepteur 3 est illustrée à la **figure 4,** pour un nombre $n_b$ de blocs égal à 1. La généralisation de cette structure à un nombre $n_b$ quelconque de blocs ne poserait pas de difficulté en soi à l'homme du métier.

Par souci de simplification, dans le mode de réalisation décrit ici, on se limite ici à une transmission mono-utilisateur. La généralisation à un environnement multi-utilisateurs ne poserait toutefois pas non plus de difficulté à l'homme du métier.

Si l'on désigne respectivement par $\mathsf{Y} = \{\mathbf{Y}_b\}_{b=1}^{nb}$, $\mathsf{S} = \{\mathbf{S}_b\}_{b=1}^{nb}$, and $\mathsf{D} = \{\mathbf{D}_b\}_{b=1}^{nb}$, l'ensemble des matrices de symboles codés reçus en sortie du canal par le récepteur 3, l'ensemble des matrices de symboles codés émis sur le canal par l'émetteur 2, et l'ensemble des matrices des bits codés en sortie de l'entrelaceur ST-$\Pi$, pour les différents blocs d'évanouissement du canal, on peut modéliser le signal reçu sur le bloc $b$ à l'instant $l$ par le modèle discret équivalent en bande de base suivant :

$$\mathbf{y}_{b;l} = \sum_{\tau=0}^{n_\tau} \mathbf{H}_{b,\tau}\mathbf{s}_{b;l-\tau} + \mathbf{w}_{b;l} \quad (2)$$

où $\mathbf{y}_{b;l} \in \mathbb{C}^{n_r}$ et $\mathbf{s}_{b;1} \in \mathbb{C}^{n_t}$ sont des vecteurs aléatoires i.i.d avec $E[\mathbf{s}_{b;l}] = \mathbf{0}_{n_t}$ et $E[\mathbf{s}_{b;l}\mathbf{s}_{b;l}^\dagger] = \mathbf{I}_{n_t}$, $E[.]$ désignant l'espérance mathématique, et où $\mathbf{w}_{b;l} \in \mathbb{C}^{n_r}$ désignent des vecteurs aléatoires i.i.d., gaussiens symétriques circulaires, de moyenne nulle et de matrice de covariance $\sigma_w^2\mathbf{I}_{n_r}$. On note $\{d_{b;t,l,j}\}_{j=1}^q$ l'ensemble des bits dans la matrice $\mathbf{D}_b$ étiquetant le symbole $\mathbf{s}_{b;t,1} \in \mathbb{C}$ dans la matrice $\mathbf{S}_b$.

Le récepteur 3 comprend un égaliseur ou détecteur LMMSE-SIC mettant en oeuvre une technique itérative d'annulation successive de l'interférence, un démodulateur DEMOD et un turbo-décodeur TURBO-DEC.

Par souci de simplification, on considère que le récepteur 3 dispose d'une estimation parfaite du canal CHNL (c'est-à-dire de l'ensemble $\mathcal{H}$) ainsi que de la matrice de covariance du bruit AWGN introduit par le canal. Toutefois, l'invention s'applique également lorsque seule une estimation imparfaite de ce canal, basée par exemple sur des symboles pilotes, est disponible au niveau du récepteur ou dans le cas d'une estimation semi-aveugle du canal.

De façon connue en soi, l'égaliseur LMMSE-SIC est composé de $n_t$ filtres de Wiener LMMSE1, ..., LMMSE$n_t$ optimisant le critère de l'erreur quadratique moyenne minimum (ou MMSE pour Minimum Mean Square Error), et estimant, à chaque itération mise en oeuvre par le récepteur itératif 3, les symboles codés émis via chaque antenne d'émission de l'émetteur 2, sur chaque bloc du canal. On note NSIC le nombre d'itérations mis en oeuvre par le récepteur 3 pour l'annulation d'interférence.

L'égaliseur LMMSE-SIC comprend par ailleurs un module de reconstruction de l'interférence INTERF ainsi que des modules 3-1, 3-2, ..., 3-$n_t$ de soustraction de l'interférence ainsi reconstruite du signal $Y = \{Y_b\}_{b=1}^{nb}$ reçu du canal, activés à chaque itération du récepteur 3. Dans le mode de réalisation décrit ici, le module de reconstruction de l'interférence INTERF utilise à cet effet des rapports logarithmiques de probabilités *a posteriori* ou LAPPR sur les bits codés délivrés par le turbo-décodeur TURBO-DEC. Comme décrit précédemment, ceci conduit à de meilleures performances dans des conditions d'interférences extrêmes que l'utilisation de rapports logarithmiques de probabilités extrinsèques ou LEXTPR.

Dans un autre mode de réalisation de l'invention, le module de reconstruction de l'interférence INTERF utilise des LEXTPR délivrés par le turbo-décodeur TURBO-DEC.

Les sorties de l'égaliseur LMMSE-SIC alimentent un banc de démodulateurs DEMOD1, ..., DEMOD$n_t$. Les sorties des démodulateurs DEMOD1, ..., DEMOD$n_t$ sont fournies à un désentrelaceur ST-$\Pi^{-1}$ apte à réaliser l'opération inverse de l'entrelaceur ST-$\Pi$. La sortie du désentrelaceur ST-$\Pi^{-1}$ est transmise à un turbo-décodeur TURBO-DEC pour décodage.

Le turbo-décodeur TURBO-DEC est un décodeur de canal itératif apte à mettre en oeuvre un nombre NDEC d'itérations de décodage, NDEC supérieur ou égal à 1. Il comprend un premier décodeur DEC1 à entrées et à sorties souples (SISO), apte à décoder les bits codés par le codeur RSC1, et un second décodeur DEC2 à entrées et à sorties souples, apte à décoder les bits codés par le codeur RSC2. Les décodeurs DEC1 et DEC2 mettent en oeuvre ici un algorithme BCJR optimisant le critère du MAP bit à bit. Chaque itération de décodage comprend l'activation successive du décodeur DEC1 puis du décodeur DEC2.

Chaque décodeur SISO, DEC1 et DEC2, prend en entrée les estimations souples des bits codés démodulés (incluant les bits systématiques) disponibles en sortie du désentrelaceur ST-$\Pi^{-1}$ ainsi que des rapports logarithmiques de probabilités *a priori* sur les bits d'information.

Dans le mode de réalisation décrit ici, chaque décodeur SISO délivre en sortie des rapports logarithmiques de probabilités extrinsèques LEXTPR sur les bits d'information (i.e. sur les bits systématiques), et des rapports logarithmiques de probabilités *a posteriori* LAPPR sur les bits codés. La façon dont les LAPPR et les LEXTPR sont générés par chacun de ces décodeurs dépend de l'algorithme de décodage implémenté par ces décodeurs (algorithme BCJR ici). Elle est connue en soi et ne sera pas décrite en détails ici.

Les LEXTPR sur les bits d'information disponibles en sortie du premier décodeur DEC1 sont entrelacés à l'aide de l'entrelaceur $\Pi$ du turbo-code puis fournis en entrée du second décodeur DEC2, comme rapports logarithmiques de probabilités *a priori* sur les bits d'information. De manière similaire, les LEXTPR sur les bits d'information disponibles en sortie du second décodeur DEC2 sont désentrelacés à l'aide du désentrelacteur $\Pi^{-1}$ qui réalise l'opération inverse de l'entrelaceur $\Pi$, puis fournis en entrée du premier décodeur DEC1. Une itération de décodage correspond à un décodage par le décodeur DEC1 suivi d'un décodage par le décodeur DEC2. Les LEXTPR fournis par le décodeur DEC2 au décodeur DEC1 sont utilisés par celui-ci à l'itération de décodage suivante comme rapports logarithmiques de probabilités *a priori* sur les bits d'information.

A l'issue de NDEC itérations de turbo-décodage, les LAPPR générés par le turbo-décodeur sur l'ensemble des bits codés (bits systématiques et bits de parité) sont collectés, après multiplexage et, le cas échéant, poinçonnage, en sortie du décodeur DEC2 pour les bits systématiques et les bits de parité générés par le code RSC2, et en sortie du décodeur DEC1 pour les bits de parité générés par le code RSC1.

Il convient de noter qu'il est possible, dans une variante de réalisation, d'évaluer à partir de ces LAPPR des LEXTPR sur l'ensemble des bits codés, en soustrayant aux LAPPR les rapports logarithmiques de probabilités intrinsèques (ou observations).

Ces LAPPR (ou dans en variante les LEXTPR évaluées à partir des LAPPR) sont ensuite entrelacés spatialement à l'aide de l'entrelaceur ST-$\Pi$ puis utilisés comme rapports logarithmiques de probabilités *a priori* pour calculer la variance (modules VAR) et la moyenne (modules AVER) des symboles STBICM transmis.

La moyenne des symboles transmis est utilisée pour reconstruire l'interférence par le module INTERF de reconstruction de l'interférence.

Le récepteur 3 se compose donc de deux schémas itératifs imbriqués :

- un schéma itératif dit externe pour l'annulation de l'interférence mettant en oeuvre NSIC itérations, et pour lequel chaque itération dite externe ou globale se traduit par une activation du détecteur LMMSE-SIC et du turbo-décodeur ; et

- un schéma itératif dit interne, propre au turbo-décodeur, mettant en oeuvre NDEC itérations, et pour lequel chaque itération se traduit par une activation du décodeur DEC1 et une activation du décodeur DEC2.

Chaque itération globale peut donc comprendre une ou plusieurs itérations internes du turbo-décodeur.

Ainsi, compte-tenu du fonctionnement précité, le récepteur 3 peut être modélisé de la façon suivante.

Partant de l'équation (2), le modèle discret équivalent en bande de base à fenêtre glissante utilisé par l'égaliseur LMMSE-SIC pour détecter le symbole $s_{b;t,l}$ dans la matrice $\mathbf{S}_b$ s'écrit sous la forme :

$$\underline{\mathbf{y}}_{b;l} = \underline{\mathbf{H}}_b \underline{\mathbf{s}}_{b;l} + \underline{\mathbf{w}}_{b;l} \qquad (3)$$

avec :

- $L_{SW} = L_1 + L_2 + 1$

- $\underline{\mathbf{y}}_{b;l} = [\mathbf{y}_{b;l-L_1}^{\mathrm{T}}, \ldots, \mathbf{y}_{b;l+L_2}^{\mathrm{T}}]^{\mathrm{T}}$

- $\underline{\mathbf{S}}_{b;l} = [\mathbf{s}_{b;l-L_1-n_\tau}^{\mathrm{T}}, \ldots, \mathbf{s}_{b;l+L_2}^{\mathrm{T}}]^{\mathrm{T}}$

- $\underline{\mathbf{w}}_{b;l} = [\mathbf{w}_{b;l-L_1}^{\mathrm{T}}, \ldots, \mathbf{w}_{b;l+L_2}^{\mathrm{T}}]^{\mathrm{T}}$

- $\underline{\mathbf{H}}_b$ une matrice de Sylvestre de dimensions $L_{SW}n_r \times (L_{SW} + n_\tau)n_t$

Ainsi, pour un indice $l$, l'indice $l'$ qui sert à designer une composante d'un vecteur varie donc de $l - L_1 - n_\tau$ à $l + L_2$. Le couple d'indices $(t',l')$ diffère du couple d'indices $(t,l)$ dès que l'un quelconque des indices est distinct. On désigne dans la suite par $\underline{\mathbf{e}}_t$ le vecteur de taille $(L_{SW} + n_\tau)n_t$ ayant un « 1 » à la position $(L_1 + n_\tau)n_t + t$.

Dans la suite de la description, $\Lambda_{D,DEC} = \{\Lambda_{D,DEC}(c_n)\}_{n=1}^{n_c}$ désigne l'ensemble des LAPPR sur les bits codés disponibles en sortie du décodeur TURBO-DEC (i.e. à la sortie du décodeur DEC2 pour les bits systématiques et les bits de parités générés par le code RSC2 et à la sortie du décodeur DEC1 pour les bits de parités générés par le code RSC1) et qui sont utilisés (après avoir été ré-entrelacés par l'entrelaceur $\Pi$) comme information *a priori* par le détecteur LMMSE-SIC.

Par ailleurs, $\{\Lambda_{D,LE}\}_{s_{b;t,l}}$ et $\{\Lambda_{D,LE}\}_{\underline{\mathbf{s}}_{b;l}}$ désignent respectivement l'ensemble des LAPPR sur les bits codés impliqués dans l'étiquetage de $s_{b;t,l}$ et l'ensemble des LAPPR sur les bits codés impliqués dans l'étiquetage de $\underline{\mathbf{s}}_{b;l}$.

Enfin $\{\Lambda_{D,LE}\}_{\underline{\mathbf{s}}_{b;l}\backslash s_{b;t,l}}$ désigne l'ensemble des LAPPR sur les bits codés impliqués dans l'étiquetage de $\underline{\mathbf{s}}_{b;l}$ privés des bits codés impliqués dans l'étiquetage de $s_{b;t,l}$.

Les étapes suivantes étant identiques pour chaque itération $i=1,...,NSIC$ du récepteur 3, l'indice désignant l'itération courante est omis. Comme mentionné précédemment, on suppose que le récepteur 3 dispose d'une estimation parfaite du canal CHNL.

a) Annulation et régénération de l'interférence par le module INTERF :

Pour estimer le symbole $s_{b;t,l}$, une estimation MMSE conditionnelle de l'interférence doit être évaluée selon :

$$\underline{\mathbf{y}}_{b;l\backslash t} = \mathrm{E}\left[\underline{\mathbf{y}}_{b;l} \mid \{\Lambda_{D,LE}\}_{\underline{\mathbf{s}}_{b;l}\backslash s_{b;t,l}}\right].$$

En pratique, une telle estimation est impossible, les composantes utiles du signal et les échantillons de bruit n'étant plus indépendants lorsqu'ils sont conditionnés par rapport à $\{\Lambda_{D,LE}\}_{\underline{\mathbf{s}}_{b;l}\backslash s_{b;t,l}}$. Deux hypothèses simplificatrices sont donc envisagées :

**Hypothèse A1** La densité de probabilité $p_{\underline{\mathbf{s}}_{b;l},\underline{\mathbf{w}}_{b;l}|\{\Lambda_{D,LE}\}_{\underline{\mathbf{s}}_{b;l}\backslash s_{b;t,l}}}\left(\underline{\mathbf{s}}_{b;l}, \underline{\mathbf{w}}_{b;l}\right)$ est factorisée selon :

$$p_{\underline{s}_{b;l},\underline{w}_{b;l}|\{\Lambda_{D,LE}\}_{\underline{s}_{b;l}\setminus s_{t;l}}}\left(\underline{s}_{b;l},\underline{w}_{b;l}\right) = P(s_{b;t,l})\, p_{\underline{w}_{b;l}}(\underline{w}_{b;l}) \prod_{(t',l')\neq(t,l)} P(s_{b;t',l'} \mid \{\Lambda_{D,LE}\}_{s_{b;t',l'}})\ (4)$$

**Hypothèse A2** La fonction de probabilité de masse $P(s_{b;t',l'}|\{\Lambda_{D,LE}\}_{s_{b;t',l'}})$ dans (4) est proportionnelle à :

$$P(s_{b;t',l'} \mid \{\Lambda_{D,LE}\}_{s_{b;t',l'}}) \propto e^{\sum_{j=1,...q} \mu_j^{-1}(s_{b;t',l'})\Lambda_{D,LE}(d_{b;t',l',j})} \qquad (5)$$

Il convient de noter que les hypothèses A1 et A2 ne sont pas vérifiées en pratique, même pour des longueurs d'entrelacement très grandes $(n_c \to \infty)$. Toutefois, elles permettent d'obtenir une approximation analytique pour modéliser le comportement du détecteur LMMSE-SIC. L'estimation MMSE de l'interférence affectant le symbole $s_{b;t,l}$ vérifie alors sous l'hypothèse A1 :

$$\underline{y}_{b;l\setminus t} = \underline{\underline{H}}_b\,(\mathbf{I}_{(L_{SW}+n_\tau)n_t} - \underline{e}_t\,\underline{e}_t^{\dagger})\,\underline{m}_{b;l}\ (6)$$

où $\underline{m}_{b;l}$ est le vecteur des symboles estimés $m_{b;t',l'} = \mathrm{E}\big[s_{b;t',l'} \mid \{\Lambda_{D,LE}\}_{s_{b;t',l'}}\big]$ évalués en tenant compte de l'hypothèse (A2).

Cette interférence est soustraite pour chaque antenne d'émission $t$ par le module 3-t du récepteur 3 à la matrice $\underline{y}_{b;l}$. Le nouveau vecteur des observations à prendre en compte pour l'itération suivante du récepteur 3 est alors : $\underline{y}_{b;l}$ $\leftarrow$ $\underline{y}_{b;l}$ - $\underline{y}_{b;l\setminus t}$ (ou de manière équivalente, si $i$ désigne l'itération courante du détecteur LMMSE-SIC :

$$\underline{y}_{b;l}^{(i)} = \underline{y}_{b;l}^{(i-1)} - \underline{y}_{b;l\setminus t}^{(i-1)}$$

).

b) Estimation LMMSE par les modules LMMSE1,...,LMMSE$n_t$ :

Le problème théorique que doit résoudre le détecteur LMMSE-SIC est de trouver le symbole estimé $\breve{s}_{b;t,l} = \underline{f}_{b;t}^{\dagger}(\underline{y}_{b;l} - \underline{y}_{b;l\setminus t})$ qui minimise l'erreur quadratique moyenne $\mathrm{E}\big[|\breve{s}_{b;t,l} - s_{b;t,l}|^2\big]$ définie par :

$$\mathrm{E}\Big[\mathrm{E}\big[|\breve{s}_{b;t,l} - s_{b;t,l}|^2 \mid \{\Lambda_{D,LE}\}_{\underline{s}_{b;l}\setminus s_{b;t,l}}\big]\Big]\ (7)$$

L'espérance mathématique extérieure dans l'équation (7) rend le filtre LMMSE $\underline{f}_{b;t}$ invariant dans le temps, avec :

$$\underline{f}_{b;t} = \underline{\underline{\Xi}}_{b;t}^{-1}\,\underline{\xi}_{b;t}$$

où :

$$\underline{\xi}_{b;t} = \mathrm{E}\big[\underline{\xi}_{b;t,l}\big]\ \text{avec}\ \underline{\xi}_{b;t,l} = \mathrm{E}\big[(\underline{y}_{b;l} - \underline{y}_{b;l\setminus t})s_{b;t,l}^* \mid \{\Lambda_{D,LE}\}_{\underline{s}_{b;l}\setminus s_{b;t,l}}\big]\ (8)$$

et

$$\underline{\underline{\Xi}}_{b;t} = \mathrm{E}\big[\underline{\underline{\Xi}}_{b;t,l}\big]\ \text{avec}\ \underline{\underline{\Xi}}_{b;t,l} = \mathrm{E}\big[(\underline{y}_{b;l} - \underline{y}_{b;l\setminus t})(\underline{y}_{b;l} - \underline{y}_{b;l\setminus t})^{\dagger} \mid \{\Lambda_{D,LE}\}_{\underline{s}_{b;l}\setminus s_{b;t,l}}\big]\ (9)$$

Le calcul de $\underline{f}_{b;t}$ présenté ci-dessus est impossible à réaliser en pratique.

Toutefois, sous l'hypothèse A1, $\underline{\xi}_{b;t}$ et $\underline{\Xi}_{b;t}$ deviennent :

$$\underline{\xi}_{b;t} = \underline{\mathbf{h}}_{b;t} = \underline{\mathbf{H}}_b \underline{\mathbf{e}}_t \text{ et } \underline{\Xi}_{b;t} = \underline{\mathbf{H}}_b \underline{\mathbf{V}}_{b\backslash t} \underline{\mathbf{H}}_b^\dagger + \sigma_w^2 \mathbf{I}_{L_{SW} n_r}$$

où $\underline{\mathbf{V}}_{b\backslash t}$ désigne la matrice de covariance inconditionnelle des symboles définie par :

$$\underline{\mathbf{V}}_{b\backslash t} = \mathbf{I}_{(L_{SW}+n_\tau)} \otimes diag\{v_{b;1},\ldots,v_{b;t-1},1,v_{b;t+1},\ldots,v_{b:n_t}\} \quad (10)$$

*diag* désignant la matrice diagonale ayant pour éléments diagonaux les éléments indiqués entre accolades, où $v_{b;t'} = \mathsf{E}[v_{b;t',l}]$ et $v_{b;t',l} = \mathsf{E}[|s_{b;t',l} - m_{b;t',l}|^2 | \{\Lambda_{D,LE}\}_{s_{b;t',l}}]$ sont évalués sous l'hypothèse A2, $\forall t' \neq t$.

On obtient alors le filtre :

$$\underline{\mathbf{f}}_{b;t} = \frac{1}{1 + \eta_{b;t}(1 - v_{b;t})} \underline{\Sigma}_b^{-1} \underline{\mathbf{h}}_{b;t} \quad (11)$$

avec $\underline{\Sigma}_b = \underline{\mathbf{H}}_b \underline{\mathbf{V}}_b \underline{\mathbf{H}}_b^\dagger + \sigma_w^2 \mathbf{I}_{L_{SW} n_r}$, $\eta_{b;t} = \underline{\mathbf{h}}_{b;t}^\dagger \underline{\Sigma}_b^{-1} \underline{\mathbf{h}}_{b;t}$ et

$$\underline{\mathbf{V}}_b = \underline{\mathbf{V}}_{b\backslash t} - (1 - v_{b;t})\underline{\mathbf{e}}_t \underline{\mathbf{e}}_t^\dagger \quad (12)$$

où $v_{b;t} = \mathsf{E}[v_{b;t,l}]$ avec $v_{b;t,l} = \mathsf{E}[|s_{b;t,l} - m_{b;t,l}|^2 | \{\Lambda_{D,LE}\}_{s_{b;t,l}}]$ évalué sous l'hypothèse (A2).

L'estimée $\hat{s}_{b;t,l}$ de $s_{b;t,l}$ s'exprime alors sous la forme :

$$\hat{s}_{b;t,l} = \underline{\mathbf{f}}_{b;t}^\dagger (\underline{\mathbf{y}}_{b,l} - \underline{\mathbf{y}}_{b;l\backslash t}) = g_{b;t} s_{b;t,l} + \zeta_{b;t,l} \quad (13)$$

avec $g_{b;t} = \underline{\mathbf{f}}_{b;t}^\dagger \underline{\mathbf{h}}_{b;t}$ et où $\zeta_{b;t,l}$ désigne le terme d'interférence et de bruit résiduel.

Sous l'hypothèse (A1), $\zeta_{b;t,l}$ dans l'équation (13) est de moyenne nulle et non corrélé avec le signal utile $s_{b;t,l}$, i.e., $\mathsf{E}[s_{b;t,l} \zeta_{b;t,l}^*] = 0$. Il a par ailleurs pour variance $\zeta_{b;t} = g_{b;t}(1 - g_{b;t})$.

Il en résulte qu'un rapport signal-sur-interférence plus bruit inconditionnel peut être défini par :

$$\gamma_{b;t} = \frac{g_{b;t}}{1 - g_{b;t}} = \frac{\eta_{b;t}}{1 - v_{b;t}\eta_{b;t}} \quad (14)$$

pour chaque bloc de canal et chaque antenne d'émission de l'émetteur 2. Ce rapport $\gamma_{b;t}$ modélise le comportement du filtre de Wiener LMMSE*t* du détecteur LMMSE-SIC du récepteur 3.

Nous introduisons maintenant deux nouvelles hypothèses A3 et A4 pour la mise en oeuvre et la modélisation du détecteur LMMSE-SIC, à savoir :

**Hypothèse A3** On remplace la moyenne statistique par une moyenne empirique, i.e. :

$$\forall b, \forall t, v_{b;t} \approx \tilde{v}_{b;t} = \frac{1}{n_s} \sum_{l=1}^{n_s} v_{b;t,l} \quad (15)$$

cette hypothèse étant valide lorsque $n_s$ est très grand.

**Hypothèse A4** La variance est identique quel que soit le bloc d'évanouissement $b$ et l'antenne d'émission tconsidérés, autrement dit :

$$\forall b, \forall t, v_{b;t} \approx v = \frac{1}{n_b n_t} \sum_{b=1}^{n_b} \sum_{t=1}^{n_t} v_{b;t} \quad (16)$$

L'hypothèse A4 n'est pas valide en pratique, même pour de grandes longueurs d'entrelacement. Toutefois, les inventeurs ont constaté que cette hypothèse n'induisait pas de dégradation des performances du détecteur LMMSE-SIC.

Sous les hypothèses A3 et A4, la matrice de covariance $\underline{\mathbf{V}}_b$ des symboles estimés s'écrit sous la forme simplifiée suivante :

$$\underline{\mathbf{V}} = \tilde{v} \mathbf{I}_{(L_{SW}+n_\tau)n_t} \quad (17)$$

où

$$\tilde{v} = \frac{1}{n_b n_t} \sum_{b=1}^{n_b} \sum_{t=1}^{n_t} \tilde{v}_{b;t} \quad (18)$$

c) Démodulation par le démodulateur DEMOD et décodage par le turbo-décodeur TURBO-DEC

Les symboles estimés $\hat{s}_{b;t,l}$ par l'égaliseur LMMSE-SIC sont utilisés comme statistiques de décision par le démodulateur DEMOD pour calculer des rapports logarithmiques de probabilités extrinsèques LEXTPR notés $\{\Lambda_{E,DEM}(d_{b;t,l,j})\}_{j=1}^q$ .

A cet effet, l'hypothèse suivante est envisagée :

**Hypothèse A5** : Dans (13), la densité de probabilité $p_{\hat{s}_{b;t,l}|s_{b;t,l}}(\hat{s}_{b;t,l})$ est $N_C(g_{b;t}s_{b;t,l}, \zeta_{b;t})$.

Sous les hypothèses A2 et A5, et dans le cas d'un étiquetage de Gray, le LEXTPR $\Lambda_{E,DEM}(d_{b;t,l,j})$ du bit étiqueté par $d_{b;t,l,j}$ s'exprime sous la forme suivante :

$$\Lambda_{E,DEM}(d_{b;t,l,j}) = \frac{\sum_{s \in C_j^{(1)}} e^{-|\hat{s}_{b;t,l} - g_{b;t}s|^2/\varsigma_{b;t}}}{\sum_{s \in C_j^{(0)}} e^{-|\hat{s}_{b;t,l} - g_{b;t}s|^2/\varsigma_{b;t}}} \quad (19)$$

Les LEXTPR, qui forment un ensemble $\Lambda_{E,DEM}$, sont ensuite désentrelacés de sorte à former un ensemble $\mathbf{\Lambda}_{I,DEC} = \{\Lambda_{I,DEC}(c_n)\}_{n=1}^{n_c}$ de rapports logarithmiques de probabilités intrinsèques, utilisés comme observations par le turbo-décodeur TURBO-DEC.

L'hypothèse suivante est alors retenue pour le décodage :

**Hypothèse A6** La densité de probabilité $p_{\Lambda_{I,DEC}|\mathbf{c}}(\Lambda_{I,DEC})$ se factorise selon :

$$p_{\Lambda_{I,DEC}|\mathbf{c}}(\mathbf{\Lambda}_{I,DEC}) = \prod_{n=1}^{n_c} p_{\Lambda_{I,DEC}(c_n)|c_n}(\Lambda_{I,DEC}(c_n)) \quad (20)$$

Cette hypothèse est vérifiée pour un entrelaceur de longueur finie mais grande. Elle permet de simplifier la tâche du décodage.

Sous l'hypothèse A6, le turbo-décodeur TURBO-DEC évalue de nouvelles LAPPR

$$\Lambda_{D,DEC} = \{\Lambda_{D,DEC}(c_n)\}_{n=1}^{n_c}$$ sur les bits codés pour l'itération suivante du récepteur itératif.

Ces LAPPR sont entrelacés par l'entrelaceur ST-$\Pi$, formant ainsi l'ensemble de LAPPR $\Lambda_{D,LE}$. Puis les moyennes des symboles transmis conditionnées à ces LAPPR sont évaluées par des modules AVER du récepteur 3 pour chaque antenne d'émission en vertu des hypothèses A1 et A2, et la variance des symboles transmis conditionnées à ces LAPPR est évaluée par un module VAR du récepteur 3 pour l'ensemble des antennes, en vertu de l'hypothèse A1, A2 et A4.

La variance est fournie à chaque détecteur LMMSE1,..., LMMSE$n_t$ pour être utilisée à l'itération suivante, tandis que les moyennes sont fournies au module de reconstruction de l'interférence INTERF.

Comme mentionné précédemment, les deux décodeurs DEC1 et DEC2 du turbo-décodeur TURBO-DEC mettent chacun en oeuvre l'algorithme BCJR et échangent entre eux des quantités probabilistes (i.e. des rapports logarithmiques de vraisemblances dans le mode de réalisation décrit ici).

Plus précisément, le premier décodeur DEC1 calcule des LAPPR sur les bits codés par le code RSC1 (bits d'information et de parité), en prenant en compte les observations $$\Lambda_{I,DEC} = \{\Lambda_{I,DEC}(c_n)\}_{n=1}^{n_c}$$ fournies par le démodulateur DEMOD et des rapports logarithmiques de probabilités *a priori* disponibles en son entrée sur les bits d'information systématiques. Ces rapports logarithmiques de probabilités *a priori* correspondent aux informations $$\Lambda_{A,DEC} = \{\Lambda_{A,DEC}(u_n)\}_{n=1}^{n_d}$$ stockées lors d'une activation précédente du turbo-décodeur (il s'agit en fait des LEXTPR sur les bits systématiques les plus récentes fournies par le second décodeur DEC2).

Le second décodeur DEC2 est ensuite activé et calcule des LAPPR sur les bits codés par le code RSC2 (bits d'information systématiques et bits de parité), en prenant en compte les observations $$\Lambda_{I,DEC} = \{\Lambda_{I,DEC}(c_n)\}_{n=1}^{n_c}$$ et des rapports logarithmiques de probabilités *a priori* disponibles à son entrée sur les bits d'information systématiques et fournis par le premier décodeur DEC1 (il s'agit en fait des LEXTPR sur les bits systématiques évalués par le premier décodeur DEC1, comme mentionné précédemment).

Les inventeurs ont constaté qu'un passage par l'égaliseur LMMSE-SIC suivi d'un passage par le premier décodeur DEC1 et d'un passage par le second décodeur DEC2 (i.e. mise en oeuvre d'une itération de décodage unique par le décodeur TURBO-DEC soit NDEC=1) conduit à de meilleures performances pour un nombre suffisant d'itérations globales du récepteur 3 qu'un schéma d'ordonnancement selon lequel un passage par l'égaliseur LMMSE-SIC suivi d'un nombre déterminé d'itérations NDEC > 1 du turbo-décodeur est envisagé. Il convient de noter toutefois qu'une dégradation de performances peut être constatée lorsque des schémas de modulation et de codage à faible rendement sont implémentés.

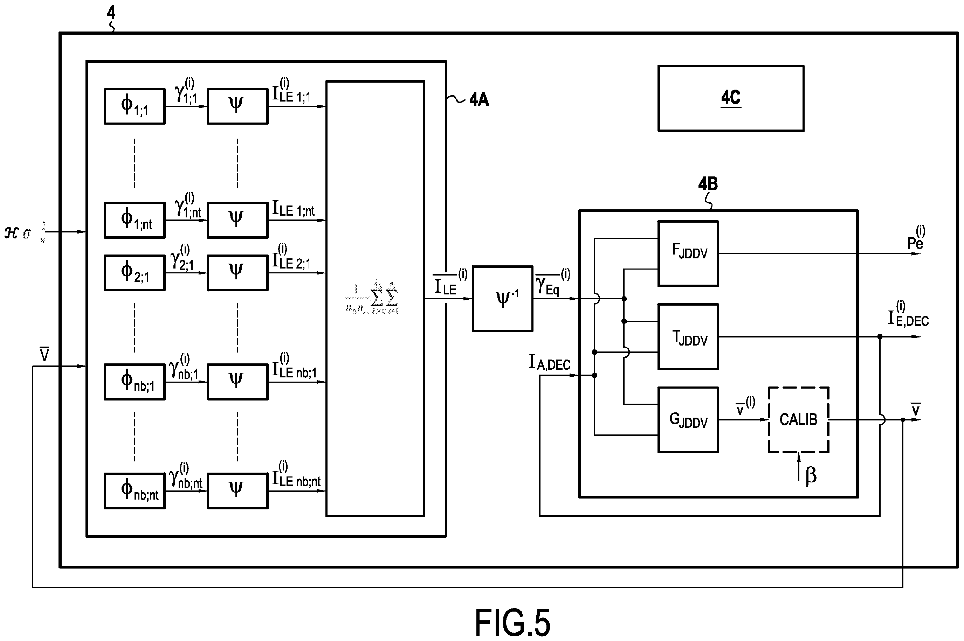

Conformément à l'invention, le récepteur 3 comprend également un dispositif de prédiction 4 des performances du système 1 selon l'invention. Ce dispositif de prédiction 4 s'appuie sur trois modules fonctionnels 4A, 4B et 4C illustrés schématiquement à la **figure 5.**

Plus précisément, le dispositif de prédiction 4 comprend un premier module de modélisation 4A, apte à modéliser le comportement de l'égalisateur LMMSE-SIC précédemment décrit, ainsi qu'un second module de modélisation 4B, apte à modéliser le comportement du démodulateur DEMOD et du turbo-décodeur TURBO-DEC. Les modules 4A et 4B sont activés par un module d'activation 4C pour prédire les performances du système 1 pour chaque itération du récepteur itératif 3.

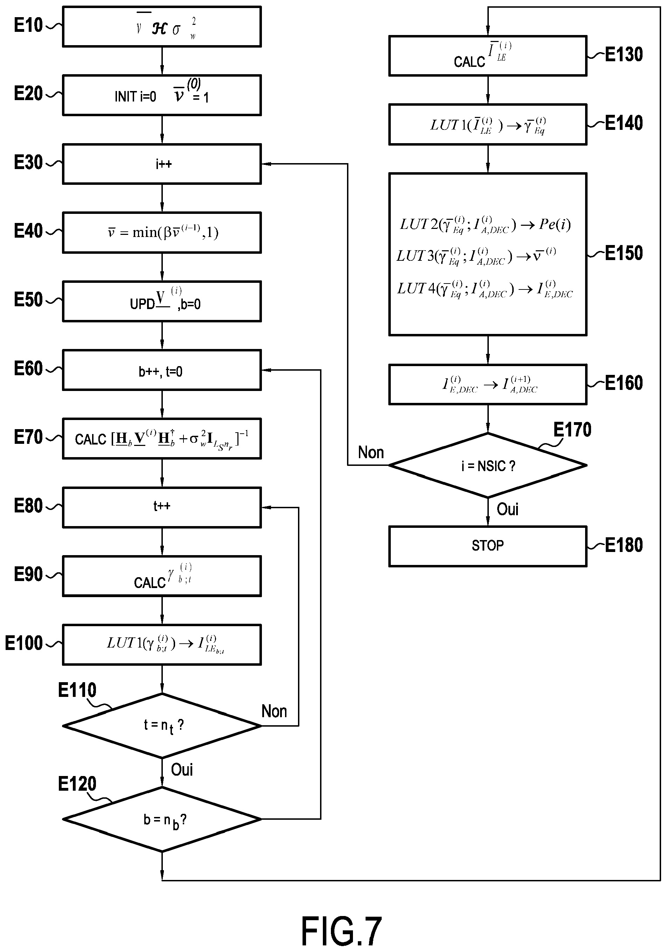

Les modules fonctionnels 4A, 4B et 4C se présentent, dans le mode de réalisation décrit ici, sous forme d'instructions logicielles. Ils seront décrits plus en détails ultérieurement en référence à la figure 7.

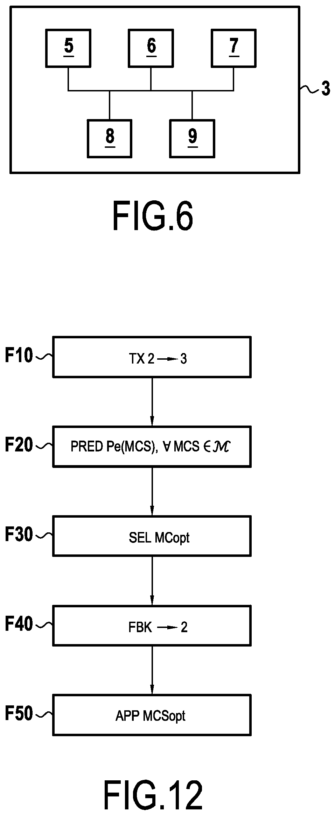

Dans le mode de réalisation décrit ici, le récepteur 3 a l'architecture matérielle d'un ordinateur, illustrée schématiquement à la **figure 6.**

Il comporte notamment un processeur 5, une mémoire morte 6, une mémoire vive 7, une mémoire non volatile 8, ainsi que des moyens de communication 9 sur le réseau NW lui permettant de communiquer notamment avec l'émetteur 2.

La mémoire morte 6 du récepteur 3 constitue un support d'enregistrement conforme à l'invention, lisible par le processeur 5 et sur lequel est enregistré un programme d'ordinateur conforme à l'invention, comportant des instructions pour l'exécution des étapes d'un procédé de prédiction conforme à l'invention décrites maintenant à la figure 5 et à la **figure 7,** dans un mode particulier de réalisation. Ce programme d'ordinateur définit, de façon équivalente, les modules fonctionnels 4A, 4B et 4C du dispositif de prédiction 4 selon l'invention et leurs interactions.

Comme mentionné précédemment, l'invention permet de prédire de façon fiable et rapide les performances du système de communication 1 sur le canal de transmission CHNL. Elle s'appuie, à cette fin, sur une modélisation de la couche physique du système 1, et plus spécifiquement du comportement du récepteur 3 et des entités qui le composent, à savoir l'égaliseur LMMSE-SIC, le démodulateur DEMOD et le turbo-décodeur TURBO-DEC.

Il apparait clairement, au vu de la description qui précède du mode de fonctionnement du récepteur itératif 3, que celui-ci se définit comme un système dynamique non-linéaire particulièrement compliqué. L'invention vise à analyser l'évolution de ce système dynamique au cours des itérations, afin de pouvoir prédire ses performances.

A cet effet, dans le mode de réalisation décrit ici, le procédé de prédiction selon l'invention emploie une approche semi-analytique pour caractériser le comportement de l'égaliseur LMMSE-SIC à chaque itération mise en oeuvre par le récepteur 3, ainsi qu'une approche stochastique pour caractériser le comportement du démodulateur DEMOD et du turbo-décodeur TURBO-DEC. Cette approche est mise en oeuvre pour chaque itération du récepteur itératif 3, autrement dit pour $i=1,...,NSIC$. Elle s'appuie sur les hypothèses simplificatrices A1 à A6 évoquées précédemment.

Des notations similaires à celles introduites précédemment pour décrire le fonctionnement du système 1 sont utilisées dans la suite de la description afin de visualiser plus aisément la correspondance entre les modélisations proposées par l'invention et les différentes variables manipulées par les entités du récepteur 3.

La prédiction des performances réalisée par le dispositif 4 de prédiction s'appuie sur diverses informations disponibles au niveau du récepteur 3 ou estimées par celui-ci, à savoir sur l'estimation du canal CHNL (autrement dit de l'ensemble $\mathcal{H}$ des $n_b$ réponses impulsionnelles finies $\mathbf{H}_b(l)$, $b=1,...,n_b$ modélisant les variations rapides du canal sur chaque bloc), une estimation $\sigma_w^2$ de la variance du bruit AWGN, et une estimation $\overline{v}$ de la variance des symboles codés de la modulation STBICM de l'émetteur 2 (étape E10). La façon dont ces informations peuvent être déterminées ou obtenues par le récepteur 3 est connue de l'homme du métier et ne sera pas décrite davantage ici.

Les différentes variables utilisées lors de la prédiction par le dispositif 4 de prédiction sont initialisées (étape E20). Parmi ces variables, figurent notamment l'indice $i$ de l'itération courante du récepteur itératif 3 considérée (initialisé à 0) et l'estimation de la variance des symboles codés en entrée de l'égaliseur LMMSE-SIC (initialisé à $\overline{v}^{(0)} = \overline{v} = 1$ sous l'hypothèse d'une puissance normalisée des symboles codés).

Une fois cette initialisation réalisée, le dispositif 4 incrémente l'indice $i$ de l'itération courante du récepteur 3 (étape E30).

Par souci de généralisation, on se place maintenant à une itération $i$ quelconque du récepteur itératif 3.

La prédiction des performances du système 1 à l'itération $i$ s'appuie sur deux phases de modélisation successives, mises en oeuvre respectivement par le premier module de modélisation 4A et par le second module de modélisation 4B du dispositif 4 de prédiction.

Au cours de la première phase, le module 4A du dispositif 4 modélise le comportement de l'égalisateur LMMSE-SIC en assimilant les $n_t \times n_b$ sorties fournies par l'égaliseur LMMSE-SIC à $n_t \times n_b$ canaux AWGN parallèles et indépendants, chaque canal étant caractérisé par un SINR noté $\gamma_{b;t}^{(i)}$. Le module 4A évalue alors, en appliquant la métrique MIESM, un SINR $\overline{\gamma}_{Eq}^{(i)}$ d'un canal AWGN équivalent à ces canaux parallèles et ayant la même information mutuelle moyenne.

Pour estimer ce SINR $\overline{\gamma}_{Eq}^{(i)}$, le module 4A met en premier lieu à jour la valeur de l'estimation v de la variance des symboles codés disponibles en entrée de l'égaliseur LMMSE-SIC (étape E40), selon l'équation suivante :

$$\overline{v} = \min(\beta\overline{v}^{(i-1)},1) \quad (21)$$

où $\beta$ désigne un facteur de pondération et $\overline{v}^{(i-1)}$ une estimation de la variance des symboles codés symboles codés déterminée lors de l'itération $i-1$ précédente par le module de modélisation 4B. Cette étape est décrite plus en détails ultérieurement.

Puis, le module 4A met à jour une matrice $\mathbf{V}^{(i)}$ de covariance des symboles estimés disponibles en entrée du détecteur LMMSE-SIC conformément à l'équation (17) introduite précédemment, avec cette nouvelle valeur de $\overline{v}$ (i.e. en affectant la valeur $\overline{v}$ à la variable $\tilde{v}$ dans l'équation (17)) (étape E50).

Le module 4A initialise par ailleurs à 0 une variable interne $b$ destinée à balayer l'ensemble des blocs du canal CHNL. Cette variable est ensuite incrémentée à chaque nouveau bloc considéré (étape E60) jusqu'à $n_b$. Au cours de cette étape, une variable interne $t$ destinée à indexer les antennes d'émission est également initialisée à 0.

Pour chaque bloc indexé par $b$, le module 4A calcule la quantité suivante (étape E70) :

$$[\underline{\mathbf{H}}_b\underline{\mathbf{V}}^{(i)}\underline{\mathbf{H}}_b^{\dagger} + \sigma_w^2\mathbf{I}_{L_S n_r}]^{-1}$$

à partir des estimations $\mathcal{H}$ du canal et $\sigma_w^2$ de la variance du bruit dont il dispose.

Puis pour chaque antenne d'émission indexée par $t$, $t=1,...,n_t$ (étape E80), le module 4A estime un rapport signal sur interférence plus bruit $\gamma_{b;t}^{(i)}$ en sortie de l'égaliseur LMMSE-SIC pour le bloc $b$ et l'antenne $t$ à partir de l'expression (14), dans laquelle $v_{b;t}$ est remplacée par $\bar{v}$ par application de l'hypothèse A4 (étape E90, modélisés par l'application de fonctions $\phi_{1,1},...,\phi_{nb,nt}$ à la figure 5).

Puis, le module 4A estime à partir de ce SINR $\gamma_{b;t}^{(i)}$ l'information mutuelle moyenne $I_{LE_{b;t}}^{(i)}$ d'un canal AWGN équivalent de variance de bruit $1/\gamma_{b;t}^{(i)}$ (sous l'hypothèse d'une puissance des symboles codés normalisée)(étape E100). Plus précisément $I_{LE_{b;t}}^{(i)}$ désigne l'information mutuelle moyenne entre l'entrée discrète $s_{b;t,l} \in C$ du canal et sa sortie $\tilde{s}_{b;t,l} = s_{b;t,l} + \varepsilon_{b;t,l}$ avec $\varepsilon_{b;t,l}$ de distribution gaussienne $N_C(0,1/\gamma_{b;t})$.

De façon connue de l'homme du métier, l'information mutuelle pour un canal AWGN et pour des entrées indépendantes identiquement et uniformément distribuées choisies dans une constellation finie A de cardinal $2^q$ est donnée par :

$$I_A(\gamma) = I(z;y) = q - \frac{1}{2^q}\sum_{x\epsilon A}\int_y P(y|x)\left[log_2\frac{\sum_{x'\epsilon A}P(y|x')}{P(y|x)}\right]$$

où z est une variable aléatoire décrivant les entrées transmises, y est une variable aléatoire décrivant le signal reçu correspondant en sortie du canal AWGN, et $P(y|z) = N_c(z,1/\gamma)$ est la probabilité de transition du canal gaussien sous-jacent dont le SNR est $\gamma$.

La valeur $I_{LE_{b;t}}^{(i)}$ dépend d'un paramètre unique, à savoir le SINR $\gamma_{b;t}^{(i)}$, autrement dit :

$$I_{LE_{b;t}}^{(i)} = \psi(\gamma_{b;t}^{(i)}) \quad (22)$$

où $\psi$ désigne une fonction monotone croissante, et par conséquent inversible, qui dépend du schéma MCS utilisé par l'émetteur 2. Il convient de noter que ce schéma est connu du récepteur, soit parce que l'émetteur 2 utilise un unique schéma MCS, soit, lorsqu'une adaptation du lien est mise en oeuvre, parce que ce schéma est identifié à partir d'une métrique de qualité du canal évaluée par le récepteur, comme mentionné précédemment.

Dans le mode de réalisation décrit ici, la fonction $\psi$ est mémorisée dans la mémoire non volatile 8 du dispositif 4 de prédiction sous la forme d'une table de correspondance LUT1 préétablie. Si plusieurs MCS peuvent être utilisés par l'émetteur, une table de correspondance LUT1 est stockée pour chaque MCS.

Une telle table de correspondance peut être aisément établie par simulation Monte-Carlo, de façon connue de l'homme du métier.

Dans un autre mode de réalisation, une forme analytique de la fonction $\psi$ peut être utilisée.

Les étapes E60 à E100 sont répétées tant que l'indice $t$ est inférieur au nombre d'antennes d'émission $n_t$ (étape E110) et l'indice $b$ est inférieur au nombre de blocs $n_b$ du canal (étape E120).

Le module 4A évalue alors la moyenne arithmétique $\bar{I}_{LE}^{(i)}$ des informations mutuelles moyennes $I_{LE_{b;t}}^{(i)}$ ainsi estimées pour chaque bloc $b$ et chaque antenne d'émission $t$ (étape E130). Autrement dit :

$$\bar{I}_{LE}^{(i)} = \frac{1}{n_b n_t}\sum_{b=1}^{n_b}\sum_{t=1}^{n_t}I_{LE_{b;t}} \quad (23)$$

Puis il détermine à partir de la valeur $\bar{I}_{LE}^{(i)}$, le SINR $\bar{\gamma}_{Eq}^{(i)}$ correspondant en appliquant la fonction inverse de

$\psi$ (étape E140), soit :

$$\overline{\gamma}_{Eq}^{(i)} = \psi^{-1}(\overline{I}_{LE}^{(i)}) = \psi^{-1}\left(\frac{1}{n_b n_t}\sum_{b=1}^{n_b}\sum_{t=1}^{n_t}I_{LE_{b;t}}\right) \quad (24)$$

En d'autres mots, le SINR $\overline{\gamma}_{Eq}^{(i)}$ est un SINR compressé selon la métrique MIESM à partir des SINR $\gamma_{b;t}^{(i)}$.

Pour déterminer $\overline{\gamma}_{Eq}^{(i)}$, le module 4A utilise ici de nouveau la table de correspondance LUT1.

Le SINR $\overline{\gamma}_{Eq}^{(i)}$ ainsi déterminé par le module 4A au cours de cette première phase de modélisation, est transmis au second module de modélisation 4B qui débute la seconde phase de modélisation conjointe du fonctionnement du démodulateur DEMOD et du turbo-décodeur TURBO-DEC.

Plus précisément, au cours de cette seconde phase de modélisation, en référence à la figure 5, le module 4B modélise la démodulation mise en oeuvre par DEMOD, le désentrelacement effectué par ST-$\Pi^{-1}$, le turbo-décodage réalisé par TURBO-DEC (un passage par DEC1 suivi d'un passage par DEC2), le ré-entrelacement par ST-$\Pi$, et le calcul de la moyenne et de la variance des symboles transmis à partir des LAPPR disponibles en sortie de TURBO-DEC par les blocs AVER et VAR du récepteur 3 respectivement pour reconstruire l'interférence.

Puis, conformément à l'invention, il détermine à partir de cette modélisation, pour l'itération courante *i* du récepteur itératif, une probabilité d'erreur de transmission $P_e(i)$ sur le canal CHNL, une estimation de la variance $\overline{v}_i$ des symboles codés en sortie du décodeur TURBO-DEC, et une information mutuelle moyenne $I_{E,DEC}^{(i)}$ entre les bits d'information et des LEXTPR associés à ces bits d'information et disponibles en sortie du décodeur TURBO-DEC (étape E150).

La probabilité d'erreur $P_e(i)$ est ici une probabilité d'erreur par bloc transmis. En variante, il peut s'agir d'une probabilité d'erreur par bit.

La modélisation faite par le module 4B s'appuie sur des fonctions préétablies bidimensionnelles, mémorisées sous forme de trois tables de correspondance tridimensionnelles LUT2, LUT3 et LUT4 dans la mémoire non volatile 8 du dispositif 4 de prédiction, et qui caractérisent le comportement conjoint du démodulateur et du turbo-décodeur TURBO-DEC pour déterminer la probabilité d'erreur $P_e(i)$ et l'information mutuelle moyenne $I_{E,DEC}^{(i)}$, ainsi que le comportement de l'entrelaceur ST-$\Pi$ et du module VAR pour la détermination de la variance $\overline{v}_i$.

Plus spécifiquement, les fonctions mémorisées dans ces tables de correspondance dépendent de deux paramètres, à savoir d'une part, le SINR $\overline{\gamma}_{Eq}^{(i)}$ évalué par le module 4A, et d'autre part, l'information mutuelle moyenne $I_{A,DEC}^{(i)}$ entre les bits d'information émis par la source SRC et les rapports de vraisemblance de probabilités *a priori* disponibles en entrée du turbo-décodeur TURBO-DEC à l'itération *i*.

Ces tables de correspondance sont générées par simulation. Elles dépendent bien entendu de la STBICM appliquée en émission. Aussi si plusieurs MCS peuvent être utilisés par l'émetteur, une table de correspondance LUT2, LUT3 et LUT4 est stockée pour chaque MCS.

Dans le mode de réalisation décrit ici, la simulation permettant de générer les tables LUT2, LUT3 et LUT4 consiste d'une part à modéliser le calcul effectué par le démodulateur DEMOD via l'équation (19) à partir du SINR $\overline{\gamma}_{Eq}^{(i)}$ et d'autre part, à modéliser l'évolution de l'information mutuelle moyenne des LEXTPR fournies par le décodeur TURBO-DEC (ou de manière équivalente de l'information mutuelle moyenne des rapports de vraisemblance de probabilités *a priori* disponibles en entrée du turbo-décodeur).

**L'Annexe 1** résume sous forme syntaxique les principales étapes mises en oeuvre lors de la simulation pour obtenir les tables de correspondance précitées.

Cette simulation résulte en la génération, pour chaque MCS envisagé, des trois tables de correspondances tridimensionnelles LUT2, LUT3 et LUT4. Ainsi, contrairement au document D1, même pour un étiquetage de Gray, la modélisation conjointe du démodulateur et du turbo-décodeur selon l'invention est réalisée selon des fonctions à deux variables d'entrée, à savoir le rapport signal sur interférence plus bruit $\overline{\gamma}_{Eq}^{(i)}$ et l'information mutuelle moyenne relative aux rapports de probabilités *a priori* sur les bits d'information générés par la source SRC.

Il convient de noter que dans le mode de réalisation décrit ici, et comme illustré à l'annexe 1, les tables de correspondance LUT2, LUT3 et LUT4 sont générées après la réalisation d'une seule itération de décodage par le décodeur TURBO-DEC.

Toutefois, en variante, on peut envisager de générer de façon similaire de telles tables en simulant un nombre NDEC >1 d'itérations de décodage.

Pour modéliser les échanges entre l'égaliseur LMMSE-SIC et le turbo-décodeur TURBO-DEC (via le démodulateur DEMOD), le module 4C met à jour l'information mutuelle $I_{A,DEC}^{(i)}$ pour l'itération *i* avec la valeur $I_{E,DEC}^{(i)}$ issue de la table LUT2 (étape E160).

Puis tant que l'indice *i* est inférieur au nombre d'itérations NSIC du récepteur 3 (réponse oui au test E170), on réitère les étapes E30 à E160. En particulier, la variance $\overline{v}_i$ déterminée à l'étape *i* est utilisée lors de l'étape *i+1* pour évaluer l'estimation de la variance $\overline{v}$ des symboles codés disponibles en entrée de l'égaliseur LMMSE-SIC selon l'équation (21) (étape E40).

Dans le mode de réalisation décrit ici, pour estimer la variance $\overline{v}$ à l'itération *i+1,* on applique conformément à l'équation (21) un facteur de pondération $\beta$ à la variance $\overline{v}_i$ déterminée à l'itération *i*.

Ce facteur est destiné ici à prendre en compte le fait que lorsque l'on utilise un décodeur LMMSE-SIC basé sur des LAPPR délivrés par le turbo-décodeur, même pour un entrelacement de canal de dimension infinie, les hypothèses A1, A2 et A4 ne sont pas valides.

Par conséquent, les filtres de Wiener $\{\mathbf{f}_{b;t}\}$ ainsi que les SINR $\{\gamma_{b;t}\}$ en sortie de ces filtres utilisés par l'égaliseurs LMMSE-SIC ne sont que des approximations, et diffèrent en pratique légèrement des quantités calculées pour générer les tables de correspondance LUT1, LUT2 et LUT3. Les SINRs réellement disponibles en sortie de l'égaliseur LMMSE-SIC sont en partique plus petits que ceux utilisés pour estimer les tables de correspondances.

Par ailleurs, la variance empirique $\overline{v}$ utilisée dans le récepteur 3 ne coïncide avec la variance lue dans la table LUT3 par le second module de modélisation 4B lors de la prédiction si $n_s$ est trop petit. Ces facteurs d'imprécision et les erreurs de prédiction en découlant s'accumulent au gré des itérations du récepteur itératif de sorte que les inventeurs ont constaté qu'en l'absence de correction de la variance $\overline{v}_i$ extraite de la table LUT3 à l'itération *i* avant de l'utiliser à l'itération suivante *i+1,* la probabilité d'erreur prédite est trop optimiste par rapport à la probabilité d'erreur que l'on obtiendrait par simulation du système 1.

Pour résoudre ce problème, une calibration simple mais efficace de la variance $\overline{v}_i$ est mise en oeuvre dans le mode de réalisation décrit ici. Cette calibration consiste à corriger la valeur de $\overline{v}_i$ par le facteur de pondération $\beta$. Plus spécifiquement, à l'étape E40, comme mentionné précédemment, $\overline{v}$ est pris égal à min$(\beta\overline{v}_i, 1)$.

Les inventeurs ont constaté, via des simulations exhaustives, que le facteur de pondération $\beta$ devant être appliqué dépend du MCS considéré, mais ne varie pas de manière significative en fonction du nombre d'antennes d'émission et de réception ni des caractéristiques du canal (i.e. sélectivité en temps et/ou en fréquence).

Comme mentionné précédemment, ce facteur de pondération vise à réduire la différence entre la probabilité d'erreur prédite par le dispositif de prédiction 4, pour chaque réalisation du canal et chaque itération *i* >1 du récepteur itératif et une probabilité d'erreur obtenue par simulation du système de communication 1, par exemple via une simulation Monte Carlo, moyennée sur différentes données et réalisations du canal de transmission.

A cet effet, différents critères peuvent être retenus pour déterminer le facteur de pondération $\beta$.

Pour illustrer ces critères, on indice par *k*, $k \in \mathbb{N}$, chaque réalisation du canal de transmission et on note $\overline{P}_e^{(i)}(k)$ la probabilité d'erreur par bloc obtenue par simulation du système 1 sur le canal de transmission CHNL et $P_e^{(i)}(\beta,k)$ la probabilité d'erreur prédite par le dispositif 4 pour la réalisation du canal indexée par *k* à l'itération *i*. **L'Annexe 2** résume rapidement les principales étapes mises en oeuvre lors de la simulation du système 1.

Un premier critère consiste à déterminer le facteur de pondération qui minimise la somme sur l'ensemble des itérations mises en oeuvre par le récepteur itératif 3 et sur un grand nombre K de réalisations du canal de transmission, des distances entre la probabilité d'erreur $P_e^{(i)}(\beta,k)$ estimée par le module 4B et la probabilité d'erreur $\overline{P}_e^{(i)}(k)$. En d'autres mots, on choisit comme facteur de pondération selon ce premier critère :

$$\beta_1 = \arg\min_{\beta} \sum_{k=1}^{K} \sum_{i=2}^{NSIC} D\left(\overline{P}_e^{(i)}(k), P_e^{(i)}(\beta,k)\right) \quad (24)$$

où $D(x,y)=|10\log_{10}(x)-10\log_{10}(y)|^2$ par exemple.

Un deuxième critère consiste à choisir le facteur de pondération qui minimise la somme sur un grand nombre K de réalisations du canal de transmission, des distances entre la probabilité d'erreur $P_e^{(i0)}(\beta,k)$ estimée par le module 4B et la probabilité d'erreur $\overline{P}_e^{(i0)}(k)$ obtenue par simulation des performances du système de transmission 1 à un itération $i0 \in \{2,...,NSIC\}$ déterminée du récepteur itératif 3, soit :

$$\beta_2 = \arg\min_\beta \sum_{k=1}^{K} D\!\left(\overline{P}_e^{(i0)}(k), P_e^{(i0)}(\beta,k)\right) \quad (25)$$

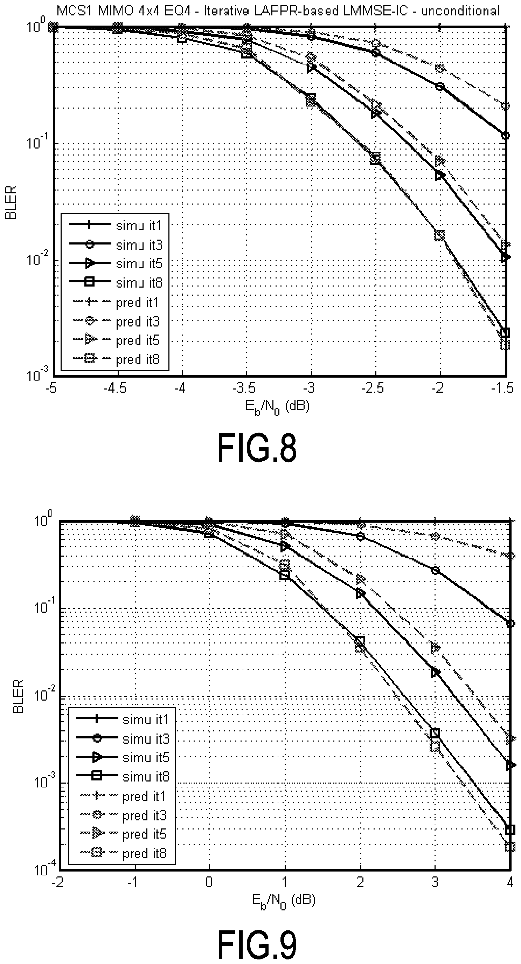

Les **figures 8 et 9** valident de manière expérimentale la méthode de prédiction selon l'invention, pour deux schémas de modulation et de codage MCS1 et MCS2 respectivement.

Le schéma de modulation et de codage MCS1 utilisé par l'émetteur 2 est une modulation codée entrelacée au niveau bit (BICM), basée sur un turbo code TC de rendement ½, réalisé à partir de deux codeurs convolutifs récursifs systématiques RSC1 et RSC2 à 4 états, de rendement ½ et de polynômes générateurs (1,5/7) (en représentation octale). Les sorties du turbo-code TC sont poinçonnées selon un motif régulier et l'entrelaceur Π est un entrelaceur pseudo-aléatoire. Le schéma MCS1 s'appuie en outre sur une modulation MDP-4 ou QPSK (Quadrature Phase Shift Keying) avec un étiquetage de Gray. L'efficacité spectrale est de 1 bit par dimension spatiale complexe.

Le schéma de modulation et de codage MCS2 utilisé par l'émetteur 2 est une modulation codée entrelacée au niveau bit (BICM), basée sur un turbo code TC de rendement ½, réalisé à partir de deux codeurs convolutifs récursifs systématiques RSC1 et RSC2 à 4 états, de rendement ½ et de polynômes générateurs (1,5/7) (en représentation octale). Les sorties du turbo-code TC sont poinçonnées selon un motif régulier et l'entrelaceur Π est un entrelaceur pseudo-aléatoire. Le schéma MCS2 s'appuie en outre sur une modulation MAQ-16 ou QAM-16 (Quadrature Amplitude Modulation) avec un étiquetage de Gray. L'efficacité spectrale est de 2 bits par dimension spatiale complexe.

La transmission s'effectue sur un canal MIMO à $n_t$ = 4 antennes d'émission et $n_r$ = 4 antennes de réception, à évanouissements de Rayleigh quasi-statique (i.e. nombre de blocs $n_b$=1), sélectif en fréquence avec 4 trajets d'énergie égale ($n_\tau$ = 3). La durée de la transmission est fixée à $n_s$ = 288 utilisations de canal ce qui correspond à 1152 bits d'information et 2304 bits codés (après poinçonnage) pour le schéma MCS1 et 2304 bits d'information et 4608 bits codés (après poinçonnage) pour le schéma MCS2.

En réception, on considère un algorithme itératif de type LMMSE-IC basé sur des LAPPR. Le nombre d'itérations mis en oeuvre par le récepteur itératif 3 est fixé à NSIC = 8, ce qui suffit en pratique à assurer la convergence. La longueur de la fenêtre glissante est égale à $L_{SW}$ = 17 ($L_1 = L_2 = 8$). Une calibration de la variance des symboles par un facteur de pondération $\beta_1$ choisi selon le premier critère décrit précédemment est appliquée à chaque itération du récepteur itératif 3 : le facteur de pondération $\beta_1$ appliqué pour compenser les approximations est le même à chaque itération, et égal à 2.0 pour le schéma MCS1 et à 2.6 pour le schéma MCS2.

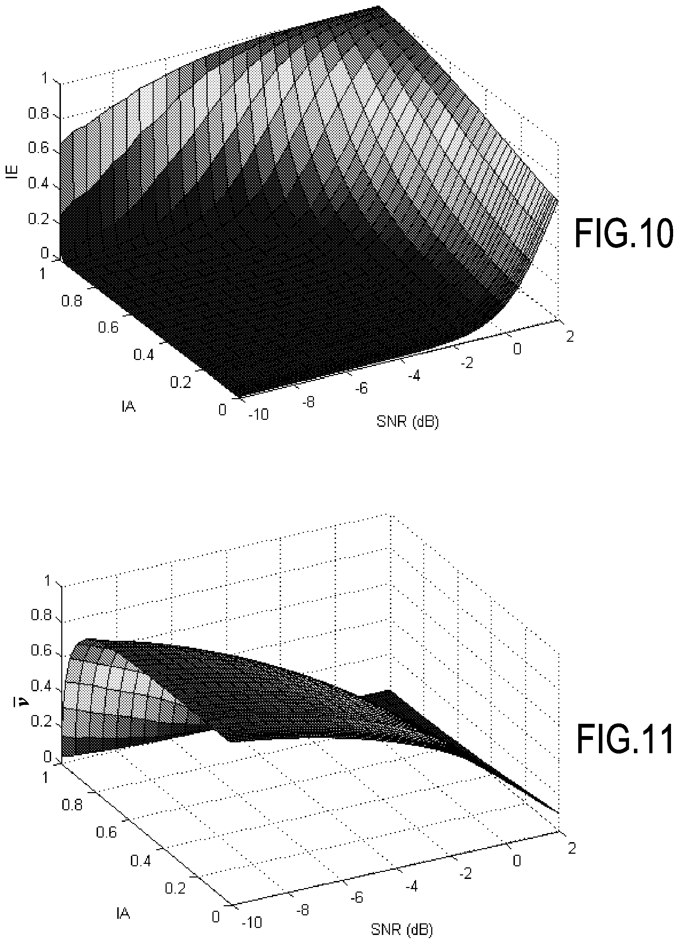

Les **figures 10 et 11** illustrent des exemples de tables de correspondance tridimensionnelles (i.e. LUT 3D) LUT3 et LU4 stockées au niveau de la mémoire non volatile du dispositif de prédiction selon l'invention pour le schéma MCS1.

La figure 8 compare, pour le schéma MCS1, la probabilité d'erreur moyenne par bloc obtenue par simulation du système de communication 1 (référencée par « simu ») avec la probabilité d'erreur par bloc obtenue à l'aide de la méthode de prédiction selon l'invention (référencée par « pred »), pour les itérations it=1, 3, 5 et 8 du récepteur itératif 3 et des valeurs de rapport signal sur bruit par bit d'information variant entre - 5dB et - 1.5dB.

La figure 9 compare, pour le schéma MCS2, la probabilité d'erreur moyenne par bloc obtenue par simulation du système de communication 1 (référencée par « simu ») avec la probabilité d'erreur par bloc obtenue à l'aide de la méthode de prédiction selon l'invention (référencée par « pred »), pour les itérations it=1, 3, 5 et 8 du récepteur itératif 3 et des valeurs de rapport signal sur bruit par bit d'information variant entre - 2dB et 4dB.

Pour les deux schémas de codage et de modulation MCS1 et MCS2, les performances du système de communication 1 prédites conformément à l'invention concordent avec les performances obtenues par simulation, ce qui valide la modélisation stochastique semi-analytique proposée pour le récepteur 3 selon l'invention. Une plus grande précision peut être obtenue en calibrant pour une itération spécifique ou en utilisant une distribution de facteurs de pondération.

Dans le mode de réalisation décrit ici, le second module de détermination 4B considère une unique itération du décodage du turbo-décodeur TURBO-DEC avant de livrer une prédiction de la probabilité d'erreur de transmission $P_e(i)$, de la variance $\overline{v}_i$ et de l'information mutuelle moyenne $I_{E,DEC}^{(i)}$ à l'itération $i$. Toutefois, en variante, des contraintes de délais peuvent nécessiter d'accélérer la convergence du récepteur itératif 3 en considérant un nombre NDEC d'itérations de décodage du turbo-décodeur supérieur à 1. On s'intéresse alors à l'évolution de l'information mutuelle moyenne associée aux LEXTPR délivrés par le deuxième décodeur DEC2 à la dernière itération de décodage, c'est-à-dire à l'itération NDEC.

Comme mentionné précédemment, l'invention s'applique également lorsque l'égaliseur LMMSE-SIC utilise non pas des LAPPR sur les bits codés délivrés par le turbo-décodeur pour évaluer la variance sur les symboles codés mais des LEXTPR. Dans ce cas, les hypothèses A1 à A6 sont vérifiées pour une taille d'entrelaceur spatio-temporel $n_c$ suffisamment grande. La correction par le facteur de pondération $\beta$ est alors moins importante voire inutile.

Par ailleurs, dans le mode de réalisation décrit ici, on s'est limité à une transmission point-à-point mono-utilisateur. En variante, l'invention s'applique également à une détection multi-utilisateurs.

Il convient en outre de noter que cette méthode de prédiction peut être aisément applicable pour prédire les performances de systèmes de transmission basés sur des schémas de modulation et de codage utilisant d'autres codes composites que des turbo-codes, et pour lesquels un décodage sous-optimal itératif est envisagé, comme par exemple des codes LDPC (Low Density Parity Check Codes).

Nous allons maintenant décrire succinctement, en référence à la **figure 12,** un exemple d'utilisation de la méthode de prédiction selon l'invention.

Selon cet exemple, l'émetteur 2 met en oeuvre une technique d'adaptation du lien radio en sélectionnant, en fonction de la qualité du lien radio le séparant du récepteur 3 (i.e. c'est-à-dire du canal de transmission), un schéma de modulation et de codage adapté au lien radio parmi un ensemble $\mathcal{M}$ de STBICM prédéterminées notées MCS1, MCS2,..., MCSN basées sur des turbo-codes.

On suppose qu'une voie de retour est prévue par le réseau NW entre le récepteur 3 et l'émetteur 2.

A chaque transmission de l'émetteur 2 vers le récepteur 3 (étape F10), ce dernier détermine, à partir d'une estimation du canal de transmission et en appliquant un procédé de prédiction selon l'invention tel que décrit précédemment, la probabilité d'erreur attendue après NSIC itérations du récepteur itératif 3 pour chaque MCS de l'ensemble $\mathcal{M}$ (étape F20).

Puis il sélectionne parmi le MCS, noté MCSopt, de l'ensemble $\mathcal{M}$ maximisant le débit du système de communication tout en vérifiant un critère de qualité de service (en général dans le cas où un protocole de retransmission existe, un taux d'erreur (ou probabilité d'erreur) par bloc inférieur à 10%)(étape F30).

L'index du MCS sélectionné est ensuite envoyé à l'émetteur 2 par le récepteur 3 sur la voie de retour (étape F40).

L'émetteur 2 applique alors le MCS sélectionné par le récepteur 3 lors de ses communications à destination du récepteur 3 jusqu'à réception d'un nouvel index de MCS (étape F50).

Il convient de noter que d'autres applications du procédé de prédiction selon l'invention peuvent être envisagées. Ainsi, par exemple, ce procédé peut être utilisé pour prédire le seuil de convergence des récepteurs itératifs de type LMMSE-IC basés sur des LAPPR ou sur des LEXTPR ou le nombre d'itérations nécessaire pour atteindre une qualité de service donnée pour un MCS fixé.

ANNEXE 1

Génération des tables de correspondance

<u>Données d'entrée</u> : schéma MCS, $n_t$, $n_{cu}$ $\phi^{-1}(I_{A,dec}) = 4\psi_2^{-1}(I_{A,dec})$ où $\psi_2(\gamma)$ est l'information mutuelle d'un canal AWGN à entrées binaires (i.e. BPSK, Binary Phase Shift Keying) i.i.d et uniformément distribuées et dont le rapport signal-sur-bruit est $\gamma$.

Pour un rapport signal sur interférence plus bruit $\gamma = \gamma_{min}$ jusqu'à $\gamma_{max}$

Pour une information mutuelle *a priori* $I_{A,DEC}$ = 0 jusqu'à 1

$$\{ \quad \sigma_A^2 = \phi^{-1}(I_{A,DEC}), \quad m_A = \sigma_A^2/2 \quad \text{Pour un bloc } bk = 1 \text{ jusqu'à } n_{bk}$$

$\{$

Génération d'un entrelaceur pseudo-aléatoire ST-$\Pi$ ; Génération d'un vecteur de bits d'informations **u** puis de la matrice **S** correspondante en fonction du schéma MCS (**u** $\to$ **c** $\to$ **D** $\to$ **S** selon les caractéristiques de l'émetteur 2) ; Création de $\tilde{\mathbf{S}}$ selon $\tilde{s}_{t,l}$ : $N_C(s_l, 1/\gamma)$ ; Simulation de la démodulation : calcul de $\{\Lambda_{E,DEM}(d_{t,l,j})\}$ selon (19) avec $\hat{s}_{t,l} = \tilde{s}_{t,l}$, $g_t = 1$ et $\zeta_t = 1/\gamma$ Simulation du désentrelacement selon ST-$\Pi^{-1}$ : $\Lambda_{E,DEM} \to \Lambda_{I,DEC}$

Génération de $\{\Lambda_{A,DEC}(u_n)\}$ avec $\Lambda_{A,DEC}(u_n)$ choisis aléatoirement selon $N((2u_n - 1)m_A, \sigma_A^2)$ Simulation d'une itération de turbo-décodage résultant en l'évaluation de $\{\Lambda_{D,DEC}(c_n)\}$ et $\{\Lambda_{E,DEC}(u_n)\}$ à partir des observations $\{\Lambda_{I,DEC}(c_n)\}$ et des *a priori* $\{\Lambda_{A,DEC}(u_n)\}$

Vérification du succès du décodage

Mise à jour des histogrammes $H_{\Lambda E|0}$ et $H_{\Lambda E|1}$ de $\{\Lambda_{E,DEC}(u_n)\}$

Ces histogrammes ont pour vocation d'estimer la densité de probabilité des LLR extrinsèques sur les bits systématiques en sortie du RSC 2 conditionnellement aux bits réellement transmis, soit $p(\Lambda_{E,DEC}(u_n)|1)=p_{\Lambda E|0}$ et $p(\Lambda_{E,DEC}(u_n)|0)=p_{\Lambda E|1}$

Simulation de l'entrelacement selon ST-$\Pi$ : $\Lambda_{D,DEC} \rightarrow \Lambda_{D,LE}$

$$\overline{v}_{(bk)} = \frac{1}{n_t n_{cu}} \sum_{t=1}^{n_t} \sum_{l=1}^{n_{cu}} v_{t,l}$$

Calcul de la variance $\{v_{t,l}\}$ en utilisant $\{\{\Lambda_{D,LE}\}_{st,l}\}$ et avec $v_{t,l} = \sum_{s \in C} P(s|\{\Lambda_{D,LE}\}_{st,l})|s-m_{t,l}|^2$ et $m_{t,l} = \sum_{s \in C} P(s|\{\Lambda_{D,LE}\}_{st,l})s$, $P(s|\{\Lambda_{D,LE}\}_{st,l})$ étant évalué selon l'équation (5)

}

$$\overline{v} = \frac{1}{n_{bk}} \sum_{bk=1}^{n_{bk}} \overline{v}_{(bk)}$$

Calcul de $P_e$, $n_{bk}$ Calcul de $I_{E,DEC}$ en utilisant les densités de probabilités $p_{\Lambda E|0}$ et $p_{\Lambda E|1}$ dérivées des histogrammes $H_{\Lambda E|0}$ et $H_{\Lambda E|1}$, comme décrit par exemple dans le document de S. Ten Brink, intitulé « Convergence Behavior of Iteratively Decoded Parallel Concatenated Codes», IEEE Transactions on Communications, vol. 49 n°10, pages 1727-1737, octobre 2001.

}

Stocker :

- dans la table de correspondance LUT2 : $P_e$ en association avec $\gamma$ et $I_{A,DEC}$ (i.e. $P_e$n= $F_{JDD_{MCS}}(\gamma,I_{A,DEC})$)
- dans la table de correspondance LUT3 : $\overline{v}$ en association avec $\gamma$ et $I_{A,DEC}$ (i.e. $\overline{v} = G_{JDD_{MCS}}(\gamma,I_{A,DEC})$), et
- dans la table de correspondance LUT4 : $I_{E,DEC}$ en association avec $\gamma$ et $I_{A,DEC}$ (i.e. $I_{E,DEC} = T_{JDD_{MCS}}(\gamma,I_{A,DEC})$)

}

ANNEXE 2

Simulation des performances du système de transmission 1

Données d'entrée de la simulation : Y, $\mathcal{H}$, $\sigma_w^2$ Initialisation : $\{\Lambda_{D,LE}^{(1)}(d_{b;t,l,j})\}$ et $\{\Lambda_{A,DEC}^{(0)}(u_n)\}$ à 0

Pour une itération $i$ = 1 jusqu'à NSIC

{ Reconstruction de l'interférence :

Calculer les moyennes $\{m_{b;t,l}^{(i)}\}$ et les variances $\{v_{b;t,l}^{(i)}\}$ en utilisant $\{\Lambda_{D,LE}^{(i)}(d_{b;t,l,j})\}$ Déduire $\tilde{v}^{(i)}$ à partir de l'équation (18) et $\underline{\mathbf{V}}^{(i)} = \tilde{v}^{(i)}\mathbf{I}_{(L_{SW}+n_\tau)n_t}$

Pour $b$ = 1 jusqu'à $n_b$

{

Calculer $[\underline{\mathbf{H}}_b\mathbf{V}^{(i)}\underline{\mathbf{H}}_b^{\dagger} + \sigma_w^2\mathbf{I}_{L_S n_r}]^{-1}$ Pour $t$ = 1 to $n_t$

{Annulation d'interférence : calculer $\{\underline{\mathbf{y}}_{b;\Lambda t}\}$ selon l'équation (6)

Filtrage de Wiener : Calculer $\mathbf{f}_{b;t}$ selon l'équation (11) et $\{\hat{s}_{b;t,l}^{(i)}\}$ selon (13) Démodulation : Calculer $\{\Lambda_{E,DEM}^{(i)}(d_{b;t,l,j})\}$ selon l'équation (19) }

}

Désentrelacement par ST-$\Pi^{-1}$ : $\Lambda_{E,DEM}^{(i)} \rightarrow \Lambda_{I,DEC}^{(i)}$ Turbo décodage (une seule itération): Calculer $\{\Lambda_{D,DEC}^{(i)}(c_n)\}$

et $\{\Lambda_{E,DEC}^{(i)}(u_n)\}$ à partir de $\{\Lambda_{I,DEC}^{(i)}(c_n)\}$ et $\{\Lambda_{A,DEC}^{(i-1)}(u_n)\}$ Mettre à jour la probabilité d'erreur $\overline{P}_e^{(i)}$

Entrelacement par ST-$\Pi$ : $\Lambda_{D,DEC}^{(i)} \rightarrow \Lambda_{D,LE}^{(i)}$ Entrelacement du turbo-décodeur : $\Lambda_{E,DEC}^{(i)} \rightarrow \Lambda_{A,DEC}^{(i)}$

}

**Revendications**

1.  Procédé de prédiction des performances d'un système de communication (1) sur un canal de transmission (CHNL), ce système (1) comprenant :

    - un émetteur (2) apte à appliquer sur des bits d'information, émis par une source, une modulation codée entrelacée par bit de sorte à générer des symboles codés, ces symboles codés étant transmis par l'émetteur sur le canal de transmission, cette modulation codée étant basée sur un turbo-code (TC) comprenant au moins deux codes constituants (RSC1, RSC2) ; et
    - un récepteur itératif (3), apte à mettre en oeuvre une technique itérative d'annulation d'interférence pour traiter les symboles codés reçus du canal de transmission, ce récepteur itératif comprenant un égaliseur (LMMSE-IC), un démodulateur (DEMOD) et un turbo-décodeur (TURBO-DEC) activés lors de chaque itération mise en oeuvre par le récepteur itératif, le turbo-décodeur comprenant au moins deux décodeurs (DEC1, DEC2) permettant de décoder respectivement les codes constituants du turbo-code, ces décodeurs étant aptes à s'échanger de manière itérative des quantités probabilistes ;

    le procédé de prédiction comprenant, pour chaque itération *i* du récepteur itératif :

    - une première étape de détermination (E70-E130) d'une valeur $\overline{\gamma}_{Eq}^{(i)}$ représentative d'un rapport signal sur interférence plus bruit en sortie de l'égaliseur, à partir d'une estimation du canal de transmission et d'une estimation $\overline{v}$ de la variance des symboles codés en entrée de l'égaliseur à l'itération *i*, cette détermination étant faite en utilisant une fonction préétablie caractérisant le comportement de l'égaliseur ; et
    - une seconde étape de détermination (E150) :

        ◦ d'une probabilité d'erreur de transmission $P_e(i)$ sur le canal ;
        ◦ d'une variance $\overline{v}_i$ des symboles codés en sortie du turbo-décodeur ; et
        ◦ d'une information mutuelle moyenne $I_{E,DEC}^{(i)}$ entre les bits d'information émis par la source et des quantités probabilistes représentatives de probabilités extrinsèques sur ces bits d'information fournies en sortie du turbo-décodeur ;

    cette détermination se faisant à partir de la valeur $\overline{\gamma}_{Eq}^{(i)}$ et d'une information mutuelle moyenne $I_{A,DEC}^{(i)}$ dite *a priori* entre les bits d'information émis par la source et des quantités probabilistes représentatives de probabilités *a priori* sur ces bits d'information disponibles en entrée du turbo-décodeur à l'itération *i*, en utilisant des fonctions préétablies caractérisant le comportement du démodulateur et du turbo-décodeur pour un nombre (NDEC) prédéterminé d'itérations de décodage mises en oeuvre par le turbo-décodeur,

    la variance $\overline{v}_i$ étant utilisée lors de la première étape de détermination, à l'itération suivante *i+1* du récepteur itératif, pour estimer la variance $\overline{v}$ des symboles codés en entrée de l'égaliseur, et l'information mutuelle moyenne $I_{E,DEC}^{(i)}$ étant utilisée lors de la seconde étape de détermination, à l'itération *i+1,* comme information mutuelle moyenne *a priori* $I_{A,DEC}^{(i+1)}.$

2.  Procédé selon la revendication 1 dans lequel la fonction utilisée pour déterminer la variance $\overline{v}_i$ est préétablie en supposant que la variance des symboles codés en sortie du turbo-décodeur (TURBO-DEC) est estimée par le récepteur itératif (3) à partir de quantités probabilistiques représentatives de probabilités *a posteriori* fournies par le turbo-décodeur sur les bits codés.

3.  Procédé selon la revendication 1 dans lequel la fonction utilisée pour déterminer la variance $\overline{v}_i$ est préétablie en supposant que la variance des symboles codés en sortie du turbo-décodeur (TURBO-DEC) est estimée par le récepteur itératif (3) à partir de quantités probabilistiques représentatives de probabilités extrinsèques fournies par le turbo-décodeur sur les bits codés.

4.  Procédé selon l'une quelconque des revendications 1 à 3 dans lequel :

- le canal (CHNL) de transmission MIMO est un canal à évanouissements par bloc comprenant *nb* de blocs ;
- l'émetteur (2) du système de communication émet les symboles codés sur *nt* antennes d'émission ; et
- l'égaliseur du récepteur itératif (3) est un égaliseur LMMSE-SIC ;

et dans lequel la première étape de détermination comprend :

- une étape d'estimation (E90) d'un rapport signal sur interférence plus bruit $\gamma_{b;t}^{(i)}$ en sortie de l'égaliseur pour chaque bloc *b* du canal à évanouissement et pour chaque antenne td'émission de l'émetteur ;

- une étape d'estimation (E100), pour chaque rapport signal interférence plus sur bruit $\gamma_{b;t}^{(i)}$ d'une information mutuelle moyenne $I_{LE_{b;t}}^{(i)}$ d'un canal à bruit blanc additif gaussien de variance $1/\gamma_{b;t}^{(i)}$, en utilisant une fonction $\psi$ inversible préétablie ;

la valeur $\overline{\gamma}_{Eq}^{(i)}$ étant déterminée (E130) selon l'équation suivante :

$$\overline{\gamma}_{Eq}^{(i)} = \psi^{-1}\left(\frac{1}{n_b n_t}\sum_{b=1}^{n_b}\sum_{t=1}^{n_t}I_{LE_{b;t}}^{(i)}\right)$$

5. Procédé selon l'une quelconque des revendications 1 à 4 dans lequel :

- la fonction préétablie caractérisant le comportement de l'égaliseur est mémorisée sous forme d'une table de correspondance bidimensionnelle ;
- les fonctions préétablies caractérisant le comportement du démodulateur et des décodeurs du turbo-décodeur sont mémorisées sous forme de tables de correspondance tridimensionnelles.

6. Procédé selon la revendication 2 dans lequel la variance des symboles codés en entrée de l'égaliseur à l'itération *i+1* est estimée selon (E40) :

$$\overline{v} = \min(\beta\overline{v}^{(i)},1)$$

où $\beta$ désigne un facteur de pondération.

7. Procédé selon la revendication 6 dans lequel le facteur de pondération $\beta$ est choisi de sorte à minimiser la somme sur l'ensemble des itérations mises en oeuvre par le récepteur itératif et sur un grand nombre K de réalisations du canal de transmission, de distances évaluées entre la probabilité d'erreur estimée lors de la seconde étape de détermination et une probabilité d'erreur obtenue par simulation des performances du système de transmission pour ces itérations et ces réalisations du canal de transmission.

8. Procédé selon la revendication 7 dans lequel le facteur de pondération $\beta$ est choisi de sorte à minimiser pour une itération déterminée du récepteur itératif la somme sur un grand nombre K de réalisations du canal de transmission de distances évaluée entre la probabilité d'erreur estimée lors de la seconde étape de détermination et une probabilité d'erreur obtenue par simulation des performances du système de transmission pour ces réalisations du canal de transmission et cette itération déterminée.

9. Procédé selon l'une quelconque des revendications 1 à 8 dans lequel la probabilité d'erreur $P_e(i)$, la variance $\overline{v}_i$ et l'information mutuelle $I_{E,DEC}^{(i)}$ sont déterminées après une itération de décodage du turbo-décodeur.

10. Procédé selon l'une quelconque des revendications 1 à 8 dans lequel la probabilité d'erreur $P_e(i)$, la variance $\overline{v}_i$ et l'information mutuelle $I_{E,DEC}^{(i)}$ *sont* déterminées après une pluralité d'itérations de décodage du turbo-décodeur.

**11.** Procédé selon l'une quelconques des revendications 1 à 10 dans lequel la modulation codée entrelacée par bit est basée sur un étiquetage de Gray.

**12.** Programme d'ordinateur comportant des instructions pour l'exécution des étapes du procédé de prédiction selon l'une quelconque des revendications 1 à 11 lorsque ledit programme est exécuté par un ordinateur.

**13.** Support d'enregistrement lisible par un ordinateur sur lequel est enregistré un programme d'ordinateur comprenant des instructions pour l'exécution des étapes du procédé de prédiction selon l'une quelconque des revendications 1 à 11.

**14.** Utilisation d'un procédé de prédiction des performances selon l'une quelconque des revendications 1 à 11 dans un procédé d'adaptation du lien radio mis en oeuvre par un système de communication comprenant un émetteur et un récepteur itératif, ce procédé d'adaptation comprenant la sélection d'une modulation codée entrelacée par bit basée sur un turbo-code parmi un ensemble prédéterminé de schémas de codage et de modulation disponibles à l'émetteur, en fonction de la probabilité d'erreur déterminée par le procédé de prédiction pour cette modulation codée entrelacée par bit à une itération prédéterminée du récepteur itératif.

**15.** Dispositif (4) de prédiction des performances d'un système (1) de communication sur un canal de transmission, ce système comprenant :

- un émetteur (2) apte à appliquer sur des bits d'information, émis par une source, une modulation codée entrelacée par bit de sorte à générer des symboles codés, ces symboles codés étant transmis par l'émetteur sur le canal de transmission (CHNL), cette modulation codée étant basée sur un turbo-code (TC) comprenant au moins deux codes constituants (RSC1, RCS2) ; et
- un récepteur itératif (3), apte à mettre en oeuvre une technique itérative d'annulation d'interférence pour traiter les symboles codés reçus du canal de transmission, ce récepteur itératif comprenant un égaliseur (LMMSE-IC), un démodulateur et un turbo-décodeur (TURBO-DEC) activés lors de chaque itération mise en oeuvre par le récepteur itératif, le turbo-décodeur comprenant au moins deux décodeurs (DEC1, DEC2) permettant de décoder respectivement les codes constituants du turbo-code, ces décodeurs étant aptes à s'échanger de manière itérative des quantités probabilistes ;

ce dispositif comprenant un module (4C) apte à activer pour chaque itération $i$ du récepteur itératif :

- un premier module de modélisation (4A), apte à déterminer une valeur $\overline{\gamma}_{Eq}^{(i)}$ représentative d'un rapport signal sur interférence plus bruit en sortie de l'égaliseur, à partir d'une estimation du canal de transmission et d'une estimation $\overline{v}$ de la variance des symboles codés en entrée de l'égaliseur à l'itération $i$, cette détermination étant faite en utilisant une fonction préétablie caractérisant le comportement de l'égaliseur ; et
- une second module de modélisation (4B), apte à déterminer :

  ◦ d'une probabilité d'erreur de transmission $P_e(i)$ sur le canal ;
  ◦ d'une variance $\overline{v}_i$ des symboles codés en sortie du turbo-décodeur ; et
  ◦ d'une information mutuelle moyenne $I_{E,DEC}^{(i)}$ entre les bits d'information émis par la source et des quantités probabilistes représentatives de probabilités extrinsèques sur ces bits d'information fournies en sortie du turbo-décodeur ;

cette détermination se faisant à partir de la valeur $\overline{\gamma}_{Eq}^{(i)}$ et d'une information mutuelle moyenne $I_{A,DEC}^{(i)}$ dite *a priori* entre les bits d'information émis par la source et des quantités probabilistes représentatives de probabilités *a priori* sur ces bits d'information disponibles en entrée du turbo-décodeur à l'itération $i$, le second module de modélisation utilisant des fonctions préétablies caractérisant le comportement du démodulateur et de chaque décodeur du turbo-décodeur,
la variance $\overline{v}_i$ étant utilisée par le premier module de modélisation, à l'itération suivante $i+1$ du récepteur itératif, pour estimer la variance $\overline{v}$ des symboles codés en entrée de l'égaliseur, et l'information mutuelle moyenne $I_{E,DEC}^{(i)}$ étant utilisée par le second module de modélisation, à l'itération $i+1,$ comme information mutuelle moyenne *a priori*

$I_{A,DEC}^{(i+1)}$.

16. Système de communication (1) comprenant :

- un émetteur (2) apte à appliquer sur des bits d'information, émis par une source, une modulation codée entrelacée par bit de sorte à générer des symboles codés, ces symboles codés étant transmis par l'émetteur sur le canal de transmission, cette modulation codée étant basée sur un turbo-code comprenant au moins deux codes constituants ; et
- un récepteur itératif (3), apte à mettre en oeuvre une technique itérative d'annulation d'interférence pour traiter les symboles codés reçus du canal de transmission, ce récepteur itératif comprenant un égaliseur, un démodulateur et un turbo-décodeur activés lors de chaque itération mise en oeuvre par le récepteur itératif, le turbo-décodeur comprenant au moins deux décodeurs permettant de décoder respectivement les codes constituants du turbo-code, ces décodeurs étant aptes à s'échanger de manière itérative des quantités probabilistes ;

ce récepteur itératif comprenant en outre un dispositif de prédiction (4) selon la revendication 15.

**Patentansprüche**

1. Verfahren zur Vorhersage der Leistungen eines Kommunikationssystems (1) über einen Übertragungskanal (CHNL), wobei dieses System (1) umfasst:

- einen Sender (2), der geeignet ist, an Informationsbits, die von einer Quelle gesandt werden, eine verschachtelte codierte Modulation pro Bit anzulegen, um codierte Symbole zu erzeugen, wobei diese codierten Symbole vom Sender über den Übertragungskanal übertragen werden, wobei diese codierte Modulation auf einem Turbocode (TC) basiert, umfassend mindestens zwei konstituierende Codes (RSC1, RSC2); und
- einen iterativen Empfänger (3), der geeignet ist, eine iterative Technik zur Interferenzaufhebung einzusetzen, um die von dem Übertragungskanal empfangenen codierten Symbole zu bearbeiten, wobei dieser iterative Empfänger einen Equalizer (LMMSE-IC), einen Demodulator (DEMOD) und einen Turbo-Decoder (TURBO-DEC) umfasst, die bei jeder Iteration, die von dem iterativen Empfänger eingesetzt wird, aktiviert werden, wobei der Turbo-Decoder mindestens zwei Decoder (DEC1, DEC2) umfasst, die es ermöglichen, die konstituierenden Codes des Turbocodes jeweils zu decodieren, wobei diese Decoder geeignet sind, auf iterative Weise probabilistische Mengen auszutauschen;

wobei das Vorhersageverfahren für jede Iteration i des iterativen Empfängers umfasst:

- einen ersten Schritt der Bestimmung (E70-E130) eines Werts $\overline{\gamma}_{Eq}^{(i)}$, der für ein Verhältnis Signal zu Interferenz plus Rauschen am Ausgang des Equalizers repräsentativ ist, auf Basis einer Schätzung des Übertragungskanals und einer Schätzung $\overline{v}$ der Varianz der codierten Symbole am Eingang des Equalizers bei der Iteration i, wobei diese Bestimmung unter Verwendung einer vorher erstellten Funktion erfolgt, die das Verhalten des Equalizers kennzeichnet; und
- einen zweiten Schritt der Bestimmung (E150):

  ◦ einer Wahrscheinlichkeit eines Übertragungsfehlers $P_e(i)$ über den Kanal;
  ◦ einer Varianz $\overline{v}_i$ der codierten Symbole am Ausgang des Turbo-Decoders; und

  ◦ einer durchschnittlichen wechselseitigen Information $I_{E,DEC}^{(i)}$ zwischen den von der Quelle gesandten Informationsbits und probabilistischen Mengen, die für extrinsische Wahrscheinlichkeiten auf diesen Informationsbits, die am Ausgang des Turbo-Decoders geliefert werden, repräsentativ sind;

wobei diese Bestimmung auf Basis des Werts $\overline{\gamma}_{Eq}^{(i)}$ und einer durchschnittlichen wechselseitigen, so genannten a priori Information $I_{A,DEC}^{(i)}$ zwischen den von der Quelle gesandten Informationsbits und probabilistischen Mengen erfolgt, die für a priori Wahrscheinlichkeiten auf diesen Informationsbits repräsentativ sind, die am Eingang des Turbo-Decoders bei der Iteration i verfügbar sind, wobei vorher erstellte Funktionen verwendet werden, die das Verhalten des Demodulators und des Turbo-Decoders für eine vorbestimmte Anzahl (NDEC) von Iterationen zur Decodierung, die von dem Turbo-Decoder eingesetzt werden, kennzeichnen,

wobei die Varianz $\overline{v}_i$ bei dem ersten Bestimmungsschritt bei der folgenden Iteration i+1 des iterativen Empfängers verwendet wird, um die Varianz $\overline{v}$ der codierten Symbole am Eingang des Equalizers zu schätzen, und wobei die durchschnittliche wechselseitige Information $I^{(i)}_{E,DEC}$ beim zweiten Bestimmungsschritt bei der Iteration i+1 als durchschnittliche wechselseitige a priori Information $I^{(i+1)}_{A,DEC}$ verwendet wird.

2. Verfahren nach Anspruch 1, bei dem die verwendete Funktion für die Bestimmung der Varianz $\overline{v}_i$ vorher erstellt wird, wobei angenommen wird, dass die Varianz der codierten Symbole am Ausgang des Turbo-Decoders (TURBO-DEC) von dem iterativen Empfänger (3) auf Basis von probabilistischen Mengen, die für a posteriori Wahrscheinlichkeiten repräsentativ sind, die von dem Turbo-Decoder auf den codierten Bits geliefert werden, geschätzt wird.

3. Verfahren nach Anspruch 1, bei dem die verwendete Funktion für die Bestimmung der Varianz $\overline{v}_i$ vorher erstellt wird, wobei angenommen wird, dass die Varianz der codierten Symbole am Ausgang des Turbo-Decoders (TURBO-DEC) von dem iterativen Empfänger (3) auf Basis von probabilistischen Mengen, die für extrinsische Wahrscheinlichkeiten repräsentativ sind, die von dem Turbo-Decoder auf den codierten Bits geliefert werden, geschätzt wird.

4. Verfahren nach einem der Ansprüche 1 bis 3, bei dem:

- der Übertragungskanal (CHNL) MIMO ein Kanal mit blockweisem Schwund, umfassend nb Blöcke, ist;
- der Sender (2) des Kommunikationssystems die codierten Symbole über nt Sendeantennen sendet; und
- der Equalizer des iterativen Empfängers (3) ein Equalizer LMMSE-SIC ist;

und bei dem der erste Bestimmungsschritt umfasst:

- einen Schritt (E90) der Schätzung eines Verhältnisses Signal zu Interferenz plus Rauschen $\gamma^{(i)}_{b;t}$ am Ausgang des Equalizers für jeden Block b des Kanals mit Schwund und für jede Sendeantenne t des Senders;

- einen Schritt (E100) der Schätzung für jedes Verhältnis Signal Interferenz plus Rauschen $\gamma^{(i)}_{b;t}$ einer durchschnittlichen wechselseitigen Information $I^{(i)}_{LE_{b;t}}$ eines Kanals mit zusätzlichem weißem gaußförmigem Rauschen der Varianz $1/\gamma^{(i)}_{b;t}$ unter Verwendung einer vorher erstellten inversiblen Funktion $\psi$;

wobei der Wert $\overline{\gamma}^{(i)}_{Eq}$ nach folgender Gleichung bestimmt wird (E130):

$$\overline{\gamma}^{(i)}_{Eq} = \psi^{-1}\left(\frac{1}{n_b n_t}\sum_{b=1}^{n_b}\sum_{t=1}^{n_t} I^{(i)}_{LE_{b;t}}\right)$$

5. Verfahren nach einem der Ansprüche 1 bis 4, bei dem:

- die vorher erstellte Funktion, die das Verhalten des Equalizers kennzeichnet, in Form einer zweidimensionalen Übereinstimmungstabelle gespeichert ist;
- die vorher erstellten Funktionen, die das Verhalten des Demodulators und der Decoder des Turbo-Decoders kennzeichnen, in Form von dreidimensionalen Übereinstimmungstabellen gespeichert sind.

6. Verfahren nach Anspruch 2, bei dem die Varianz der codierten Symbole am Eingang des Equalizers bei der Iteration i+1 geschätzt wird nach (E40):

$$\overline{v} = \min(\beta \overline{v}^{(i)}, 1)$$

wobei $\beta$ einen Gewichtungsfaktor bezeichnet.

**7.** Verfahren nach Anspruch 6, bei dem der Gewichtungsfaktor $\beta$ derart gewählt ist, dass die Summe über die Gesamtheit der vom iterativen Empfänger eingesetzten Iterationen und über eine große Anzahl K von Ausführungen des Übertragungskanals von bewerteten Distanzen zwischen der im zweiten Bestimmungsschritt geschätzten Fehlerwahrscheinlichkeit und einer Fehlerwahrscheinlichkeit, die durch Simulation der Leistungen des Übertragungssystems für diese Iterationen und diese Ausführungen des Übertragungskanals erhalten wird, minimiert wird.

**8.** Verfahren nach Anspruch 7, bei dem der Gewichtungsfaktor $\beta$ derart gewählt ist, dass für eine bestimmte Iteration des iterativen Empfängers die Summe über eine große Anzahl K von Ausführungen des Übertragungskanals von bewerteten Distanzen zwischen der im zweiten Bestimmungsschritt geschätzten Fehlerwahrscheinlichkeit und einer Fehlerwahrscheinlichkeit, die durch Simulation der Leistungen des Übertragungssystems für diese Ausführungen des Übertragungskanals und diese bestimmte Iteration erhalten wird, minimiert wird.

**9.** Verfahren nach einem der Ansprüche 1 bis 8, bei dem die Fehlerwahrscheinlichkeit $P_e(i)$, die Varianz $\overline{v}_i$ und die wechselseitige Information $I_{E,DEC}^{(i)}$ nach einer Iteration zur Decodierung des Turbo-Decoders bestimmt werden.

**10.** Verfahren nach einem der Ansprüche 1 bis 8, bei dem die Fehlerwahrscheinlichkeit $P_e(i)$, die Varianz $\overline{v}_i$ und die wechselseitige Information $I_{E,DEC}^{(i)}$ nach einer Vielzahl von Iterationen zur Decodierung des Turbo-Decoders bestimmt werden.

**11.** Verfahren nach einem der Ansprüche 1 bis 10, bei dem die verschachtelte codierte Modulation pro Bit auf einer Gray-Etikettierung basiert.

**12.** Computerprogramm, umfassend Befehle für die Ausführung der Schritte des Vorhersageverfahrens nach einem der Ansprüche 1 bis 11, wenn das Programm von einem Computer ausgeführt wird.

**13.** Aufzeichnungsträger, der von einem Computer lesbar ist, auf dem ein Computerprogramm aufgezeichnet ist, umfassend Befehle für die Ausführung der Schritte des Vorhersageverfahrens nach einem der Ansprüche 1 bis 11.

**14.** Verwendung eines Verfahrens zur Vorhersage der Leistungen nach einem der Ansprüche 1 bis 11 in einem Verfahren zur Anpassung der Funkverbindung, die von einem Kommunikationssystem, umfassend einen Sender und einen iterativen Empfänger, eingesetzt wird, wobei dieses Anpassungsverfahren die Auswahl einer verschachtelten codierten Modulation pro Bit basierend auf einem Turbocode unter einer vorbestimmten Gesamtheit von Codierungs- und Modulationsschemata, die am Sender verfügbar sind, in Abhängigkeit von der durch das Vorhersageverfahren für diese verschachtelte codierte Modulation pro Bit bei einer vorbestimmten Iteration des iterativen Empfängers bestimmten Fehlerwahrscheinlichkeit.

**15.** Vorrichtung (4) zur Vorhersage der Leistungen eines Kommunikationssystems (1) über einen Übertragungskanal, wobei dieses System umfasst:

  - einen Sender (2), der geeignet ist, an Informationsbits, die von einer Quelle gesandt werden, eine verschachtelte codierte Modulation pro Bit anzulegen, um codierte Symbole zu erzeugen, wobei diese codierten Symbole vom Sender über den Übertragungskanal (CHNL) übertragen werden, wobei diese codierte Modulation auf einem Turbocode (TC) basiert, umfassend mindestens zwei konstituierende Codes (RSC1, RSC2); und
  - einen iterativen Empfänger (3), der geeignet ist, eine iterative Technik zur Interferenzaufhebung einzusetzen, um die von dem Übertragungskanal empfangenen codierten Symbole zu bearbeiten, wobei dieser iterative Empfänger einen Equalizer (LMMSE-IC), einen Demodulator und einen Turbo-Decoder (TURBO-DEC) umfasst, die bei jeder Iteration, die von dem iterativen Empfänger eingesetzt wird, aktiviert werden, wobei der Turbo-Decoder mindestens zwei Decoder (DEC1, DEC2) umfasst, die es ermöglichen, die konstituierenden Codes des Turbocodes jeweils zu decodieren, wobei diese Decoder geeignet sind, auf iterative Weise probabilistische Mengen auszutauschen;

wobei diese Vorrichtung ein Modul (4C) umfasst, das geeignet ist, für jede Iteration i des iterativen Empfängers zu aktivieren:

- ein erstes Modellierungsmodul (4A), das geeignet ist, einen Wert $\overline{\gamma}_{Eq}^{(i)}$ zu bestimmen, der für ein Verhältnis Signal zu Interferenz plus Rauschen am Ausgang des Equalizers repräsentativ ist, auf Basis einer Schätzung des Übertragungskanals und einer Schätzung $\overline{v}$ der Varianz der codierten Symbole am Eingang des Equalizers bei der Iteration i, wobei diese Bestimmung unter Verwendung einer vorher erstellten Funktion erfolgt, die das Verhalten des Equalizers kennzeichnet; und
- ein zweites Modellierungsmodul (4B), das geeignet ist, zu bestimmen:

  ◦ eine Wahrscheinlichkeit eines Übertragungsfehlers $P_e(i)$ über den Kanal;
  ◦ ein Varianz $\overline{v}_i$ der codierten Symbole am Ausgang des Turbo-Decoders; und

  ◦ eine durchschnittliche wechselseitige Information $I_{E,DEC}^{(i)}$ zwischen den von der Quelle gesandten Informationsbits und probabilistischen Mengen, die für extrinsische Wahrscheinlichkeiten auf diesen Informationsbits, die am Ausgang des Turbo-Decoders geliefert werden, repräsentativ sind;

wobei diese Bestimmung auf Basis des Werts $\overline{\gamma}_{Eq}^{(i)}$ und einer durchschnittlichen wechselseitigen, so genannten a priori Information $I_{A,DEC}^{(i)}$ zwischen den von der Quelle gesandten Informationsbits und probabilistischen Mengen erfolgt, die für a priori Wahrscheinlichkeiten auf diesen Informationsbits repräsentativ sind, die am Eingang des Turbo-Decoders bei der Iteration i verfügbar sind, wobei das zweite Modellierungsmodul vorher erstellte Funktionen verwendet, die das Verhalten des Demodulators und jedes Decoders des Turbo-Decoders kennzeichnen, wobei die Varianz $\overline{v}_i$ von dem ersten Modellierungsmodul bei der folgenden Iteration i+1 des iterativen Empfängers verwendet wird, um die Varianz $\overline{v}$ der codierten Symbole am Eingang des Equalizers zu schätzen, und wobei die durchschnittliche wechselseitige Information $I_{E,DEC}^{(i)}$ von dem zweiten Modellierungsmodul bei der Iteration i+1 als durchschnittliche wechselseitige a priori Information $I_{A,DEC}^{(i+1)}$ verwendet wird.

16. Kommunikationssystem (1), umfassend:

- einen Sender (2), der geeignet ist, an Informationsbits, die von einer Quelle gesandt werden, eine verschachtelte codierte Modulation pro Bit anzulegen, um codierte Symbole zu erzeugen, wobei diese codierten Symbole vom Sender über den Übertragungskanal übertragen werden, wobei diese codierte Modulation auf einem Turbocode basiert, umfassend mindestens zwei konstituierende Codes; und
- einen iterativen Empfänger (3), der geeignet ist, eine iterative Technik zur Interferenzaufhebung einzusetzen, um die von dem Übertragungskanal empfangenen codierten Symbole zu bearbeiten, wobei dieser iterative Empfänger einen Equalizer, einen Demodulator und einen Turbo-Decoder umfasst, die bei jeder Iteration, die von dem iterativen Empfänger eingesetzt wird, aktiviert werden, wobei der Turbo-Decoder mindestens zwei Decoder umfasst, die es ermöglichen, die konstituierenden Codes des Turbocodes jeweils zu decodieren, wobei diese Decoder geeignet sind, auf iterative Weise probabilistische Mengen auszutauschen;

wobei dieser iterative Empfänger ferner eine Vorhersagevorrichtung (4) nach Anspruch 15 umfasst.

**Claims**

1. Method for predicting performance levels of a communication system (1) over a transmission channel (CHNL), this system (1) comprising:

- a transmitter (2) capable of applying to information bits, transmitted by a source, a bit-interleaved coded modulation so as to generate coded symbols, these coded symbols being transmitted by the transmitter over the transmission channel, this coded modulation being based on a turbo-code (TC) comprising at least two component codes (RSC1, RSC2); and
- an iterative receiver (3) capable of implementing an iterative interference cancellation technique for processing the coded symbols received from the transmission channel, this iterative receiver comprising an equalizer (LMMSE-IC), a demodulator (DEMOD) and a turbo-decoder (TURBO-DEC) activated on each iteration implemented by the iterative receiver, the turbo-decoder comprising at least two decoders (DEC1, DEC2) making it possible to respectively decode the component codes of the turbo-code, these decoders being capable of iteratively exchanging probabilistic quantities;

the prediction method comprising, for each iteration; of the iterative receiver:

- a first step of determination (E70-E130) of a value $\overline{\gamma}_{Eq}^{(i)}$ representative of a signal-to-interference-plus-noise ratio at the output of the equalizer, from an estimation of the transmission channel and an estimation $\overline{v}$ of the variance of the coded symbols at the input of the equalizer on the iteration i, this determination being made by using a pre-established function characterizing the behaviour of the equalizer; and
- a second step of determination (E150):

  ◦ of a probability of transmission error $P_e(i)$ on the channel;
  ◦ of a variance $\overline{v}_i$ of the coded symbols at the output of the turbo-decoder; and

  ◦ of a mean mutual information $I_{E,DEC}^{(i)}$ between the information bits transmitted by the source and probabilistic quantities representative of extrinsic probabilities on these information bits supplied at the output of the turbo-decoder;

this determination being made from the value $\overline{\gamma}_{Eq}^{(i)}$ and a so-called *a priori* mean mutual information $I_{A,DEC}^{(i)}$ between the information bits transmitted by the source and probabilistic quantities representative of *a priori* probabilities on these information bits available at the input of the turbo-decoder on the iteration *i,* by using pre-established functions characterizing the behaviour of the demodulator and of the turbo-decoder for a predetermined number (NDEC) of decoding iterations implemented by the turbo-decoder,

the variance $\overline{v}_i$ being used in the first determination step, on the next iteration *i+1* of the iterative receiver, to estimate

the variance $\overline{v}$ of the coded symbols at the input of the equalizer, and the mean mutual information $I_{E,DEC}^{(i)}$ being

used in the second determination step, on the iteration *i+1*, as *a priori* mean mutual information $I_{A,DEC}^{(i+1)}$.

2. Method according to Claim 1, in which the function used to determine the variance $\overline{v}_i$ is pre-established by assuming that the variance of the coded symbols at the output of the turbo-decoder (TURBO-DEC) is estimated by the iterative receiver (3) from probabilistic quantities representative of *a posteriori* probabilities supplied by the turbo-decoder on the coded bits.

3. Method according to Claim 1, in which the function used to determine the variance $\overline{v}_i$ is pre-established by assuming that the variance of the coded symbols at the output of the turbo-decoder (TURBO-DEC) is estimated by the iterative receiver (3) from probabilistic quantities representative of extrinsic probabilities supplied by the turbo-decoder on the coded bits.

4. Method according to any one of Claims 1 to 3, in which:

   - the MIMO transmission channel (CHNL) is a blockwise-fading channel comprising nb blocks;
   - the transmitter (2) of the communication system transmits the coded symbols on nt transmission antennas; and
   - the equalizer of the iterative receiver (3) is an LMMSE-SIC equalizer;

   and in which the first determination step comprises:

   - a step of estimation (E90) of a signal-to-interference-plus-noise ratio $\gamma_{b;t}^{(i)}$ at the output of the equalizer for each block b of the fading channel and for each transmission antenna t of the transmitter;

- a step of estimation (E100), for each signal-to-interference-plus-noise ratio $\gamma_{b;t}^{(i)}$, of a mean mutual information $I_{LE_{b;t}}^{(i)}$ of an additive white Gaussian noise channel of variance $1/\gamma_{b;t}^{(i)}$, by using a pre-established invertible function $\Psi$; the value $\overline{\gamma}_{Eq}^{(i)}$ being determined (E130) according to the following equation:

$$\overline{\gamma}_{Eq}^{(i)} = \psi^{-1}\left(\frac{1}{n_b n_t}\sum_{b=1}^{n_b}\sum_{t=1}^{n_t} I_{LE_{b;t}}^{(i)}\right)$$

5. Method according to any one of Claims 1 to 4, in which:

   - the pre-established function characterizing the behaviour of the equalizer is stored in the form of a two-dimensional mapping table;
   - the pre-established functions characterizing the behaviour of the demodulator and of the decoders of the turbo-decoder are stored in the form of three-dimensional mapping tables.

6. Method according to Claim 2, in which the variance of the coded symbols at the input of the equalizer on the iteration *i+1* is estimated according to (E40):

$$\overline{v} = \min(\beta\overline{v}^{(i)}, 1)$$

   in which $\beta$ denotes a weighting factor.

7. Method according to Claim 6, in which the weighting factor $\beta$ is chosen so as to minimize the sum over all the iterations implemented by the iterative receiver and over a large number K of realizations of the transmission channel, of distances evaluated between the estimated probability of error in the second determination step and a probability of error obtained by simulation of the performance levels of the transmission system for these iterations and these realizations of the transmission channel.

8. Method according to Claim 7, in which the weighting factor $\beta$ is chosen so as to minimize, for a determined iteration of the iterative receiver, the sum over a large number K of realizations of the transmission channel of distances evaluated between the estimated probability of error in the second determination step and a probability of error obtained by simulation of the performance levels of the transmission system for these realizations of the transmission channel and this determined iteration.

9. Method according to any one of Claims 1 to 8, in which the probability of error $P_e(i)$, the variance $\overline{v}_i$ and the mutual information $I_{E,DEC}^{(i)}$ are determined after a decoding iteration of the turbo-decoder.

10. Method according to any one of Claims 1 to 8, in which the probability of error $P_e(i)$, the variance $\overline{v}_i$ and the mutual information $I_{E,DEC}^{(i)}$ are determined after a plurality of decoding iterations of the turbo-decoder.

11. Method according to any one of Claims 1 to 10, in which the bit-interleaved coded modulation is based on a Gray labelling.

12. Computer program comprising instructions for the execution of the steps of the prediction method according to any one of Claims 1 to 11 when said program is run by a computer.

13. Computer-readable storage medium on which is stored a computer program comprising instructions for the execution of the steps of the prediction method according to any one of Claims 1 to 11.

14. Use of a method for predicting performance levels according to any one of Claims 1 to 11 in a radio link adaptation method implemented by a communication system comprising a transmitter and an iterative receiver, this adaptation method comprising the selection of a bit-interleaved coded modulation based on a turbo-code out of a predetermined set of coding and modulation schemes available to the transmitter, as a function of the probability of error determined by the prediction method for this bit-interleaved coded modulation on a predetermined iteration of the iterative receiver.

15. Device (4) for predicting performance levels of a communication system (1) on a transmission channel, this system comprising:

- a transmitter (2) capable of applying to information bits, transmitted by a source, a bit-interleaved coded modulation so as to generate coded symbols, these coded symbols being transmitted by the transmitter over the transmission channel (CHNL), this coded modulation being based on a turbo-code (TC) comprising at least two component codes (RSC1, RSC2); and
- an iterative receiver (3), capable of implementing an iterative interference cancellation technique for processing the coded symbols received from the transmission channel, this iterative receiver comprising an equalizer (LMMSE-IC), a demodulator and a turbo-decoder (TURBO-DEC) activated on each iteration implemented by the iterative receiver, the turbo-decoder comprising at least two decoders (DEC1, DEC2) making it possible to respectively decode the component codes of the turbo-code, these decoders being capable of iteratively exchanging probabilistic quantities;

this device comprising a module (4C) capable of activating, for each iteration i of the iterative receiver:

- a first modelling module (4A), capable of determining a value $\overline{\gamma}_{Eq}^{(i)}$ representative of a signal-to-inference-plus-noise ratio at the output of the equalizer, from an estimation of the transmission channel and an estimation $\overline{v}$ of the variance of the coded symbols at the input of the equalizer on the iteration $i$, this determination being made by using a pre-established function characterizing the behaviour of the equalizer; and
- a second modelling module (4B), capable of determining:

   ∘ a probability of transmission error $P_e(i)$ on the channel;
   ∘ a variance $\overline{v}_i$ of the coded symbols at the output of the turbo-decoder; and

   ∘ a mean mutual information $I_{E,DEC}^{(i)}$ between the information bits transmitted by the source and probabilistic quantities representative of extrinsic probabilities on these information bits supplied at the output of the turbo-decoder;

this determination being made from the value $\overline{\gamma}_{Eq}^{(i)}$ and from a so-called a *priori* mean mutual information $I_{A,DEC}^{(i)}$ between the information bits transmitted by the source and probabilistic quantities representative of *a priori* probabilities on these information bits available at the input of the turbo-decoder on the iteration i, the second modelling module using pre-established functions characterizing the behaviour of the demodulator and of each decoder of the turbo-decoder, the variance $\overline{v}_i$ being used by the first modelling module, on the next iteration $i+1$ of the iterative receiver, to estimate the variance $\overline{v}$ of the coded symbols at the input of the equalizer, and the mean mutual information $I_{E,DEC}^{(i)}$ being used by the second modelling module, on the iteration $i+1$, as a *priori* mean mutual information $I_{A,DEC}^{(i+1)}$.

16. Communication system (1) comprising:

- a transmitter (2) capable of applying to information bits, transmitted by a source, a bit-interleaved coded modulation so as to generate coded symbols, these coded symbols being transmitted by the transmitter over the transmission channel, this coded modulation being based on a turbo-code comprising at least two component codes; and

- an iterative receiver (3), capable of implementing an iterative interference cancellation technique for processing the coded symbols received from the transmission channel, this iterative receiver comprising an equalizer, a demodulator and a turbo-decoder activated on each iteration implemented by the iterative receiver, the turbo-decoder comprising at least two decoders making it possible to respectively decode the component codes of the turbo-code, these decoders being capable of iteratively exchanging probabilistic quantities;

this iterative receiver further comprising a prediction device (4) according to Claim 15.

FIG.1

FIG.2

**2**

FIG.3

**FIG.4**

TURBO-DEC

DEC1

DEC2

$\pi$

$\pi^{-1}$

$\Delta_{A, DEC}$

$\Delta_{E, DEC}$

$\Delta_{D, DEC}$

ST $\pi$

ST $\pi^{-1}$

ST $\pi$

$\Delta_{D, LE}$

$\Delta_{D, LE}$

$\Delta_{D, LE}$

$\Delta_{D, DEM1}$

$\Delta_{D, DEM2}$

$\Delta_{D, DEMn}$

AVER

AVER

AVER

DEMOD

DEMOD1

DEMOD2

DEMODnt

VAR

VAR

VAR

LMMSE-1C

INTERF

LMMSE1

LMMSE2

LMMSEnt

3A

3B

3nt

4

Y

FIG.5

FIG.6

FIG.12

FIG.7

FIG.8

FIG.9

FIG.10

FIG.11

**EP 2 957 057 B1**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Littérature non-brevet citée dans la description

- **E. OHLMER ; G. FETTWEIS.** Link adaptation in linearly precoded closed-loop MIMO-OFDM systems with linear receivers. *Proceedings IEEE ICC'09,* Juin 2009
- **K. BRUENINGHAUS et al.** Link performance models for system level simulations of broadband radio access systems. *Proceedings IEEE PIMRC'05,* Septembre 2005, vol. 4, 2306-2311
- **R. VISOZ et al.** Semi-analytical performance prediction methods for iterative LMMSE-IC multiuser MIMO joint decoding. *IEEE Transactions on Communications,* Septembre 2010, vol. 58 (9), 2576-2589
- **S. TEN BRINK.** Convergence Behavior of Iteratively Decoded Parallel Concatenated Codes. *IEEE Transactions on Communications,* Octobre 2001, vol. 49 (10), 1727-1737